# EUROPEAN PATENT APPLICATION

(11) **EP 2 233 508 A1**
(43) Date of publication of application: **29.09.2010**
(21) Application number: 08859370.2
(22) Date of filing: 04.12.2008
(51) Int. Cl.: C08G 61/12, C09K 11/06, H01L 51/50, H05B 33/10

(54) **POLYMER COMPOUND AND ORGANIC ELECTROLUMINESCENT DEVICE USING THE SAME**

(30) Priority: 11.12.2007 JP 2007319787
(71) Applicant: Idemitsu Kosan Co., Ltd., Chiyoda-ku Tokyo 100-8321 (JP)
(72) Inventor: MIZUKI, Yumiko, Sodegaura-shi Chiba 299-0293 (JP); ITO, Mitsunori, Sodegaura-shi Chiba 299-0293 (JP)
(74) Representative: Vossius & Partner
(86) International application number: PCT/JP2008/072077
(87) International publication number: WO 2009/075223

(57) **Abstract**

Provided are a high polymer compound comprising a repeating unit having a function of a dopant and a repeating unit having a function of a host, a material for organic electroluminescence containing the above high polymer compound and an organic electroluminescence device comprising an anode, a cathode and an organic compound layer comprising a layer interposed between the anode and the cathode, wherein a layer of the above organic compound layers is a light emitting layer, and the organic compound layer contains the material for organic electroluminescence described above. The above high polymer compound is useful as a light emitting material and can achieve a high polymer EL device which is excellent in device characteristics such as a lifetime, a luminous efficiency and the like.

## Description

### BACKGROUND OF THE INVENTION

The present invention relates to a high polymer compound comprising a repeating unit having a function of a dopant and a repeating unit having a function of a host, a material for organic electroluminescence (EL) obtained by using the same, an organic EL device, a solution and a method for forming a thin film.

### RELATED ART

High polymer electroluminescence materials have the advantage that a film thereof can be formed by a method in which a solution thereof is coated or printed, and various kinds thereof are investigated. For example, high polymer compounds comprising an aromatic unit having a diarylamino group and a unit having structures of fluorene, dibenzofuran and dibenzothiophene are reported (patent documents 1 and 2). However, light emitting devices prepared by using the high polymer compounds described above have involved the problem that device characteristics such as a lifetime (half life), a luminous efficiency and the like are not necessarily satisfactory.
Patent document 1: Japanese Patent Application Laid-Open No. 162009/2007
Patent document 2: International Publication WO2005/049546

### DISCLOSURE OF THE INVENTION

An object of the present invention is to provide a high polymer compound useful as a light emitting material and capable of achieving a high polymer EL device which is excellent in device characteristics such as a lifetime, a luminous efficiency and the like and a material for organic electroluminescence, an organic EL device, a solution and a method for forming a thin film each achieved by using the above high polymer compound.

Intensive investigations repeated by the present inventors in order to achieve the object described above have resulted in finding that the object is achieved by using as an organic EL material, a high polymer compound comprising at least one repeating unit A selected from divalent groups derived from compounds represented by the following Formulas (1) to (4) and at least one repeating unit B selected from the following Formulas (5) and (6), and thus the present invention has been completed.

That is, the present invention provides the inventions related to a high polymer compound, a material for organic EL, an organic EL device, a solution and a method for forming a thin film each shown below. (1) A high polymer compound comprising at least one repeating unit A selected from divalent groups derived from compounds represented by the following Formulas (1) to (4) and at least one repeating unit B selected from the following Formulas (5) and (6):

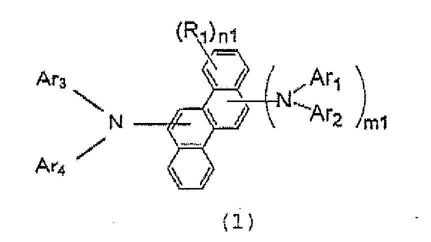

(wherein Ar₁ to Ar₄ each represent independently a substituted or non-substituted aryl group having 6 to 60 ring-forming carbon atoms or a substituted or non-substituted aromatic heterocyclic group having 3 to 40 ring-forming atoms, and Ar₁ to Ar₄ may be the same as or different from each other; R₁ represents a substituted or non-substituted alkyl group having 1 to 50 ring-forming carbon atoms, a substituted or non-substituted aryl group having 6 to 60 ring-forming carbon atoms, a substituted or non-substituted amino groups a substituted or non-substituted silyl group, a substituted or non-substituted alkoxy group having 1 to 50 ring-forming carbon atoms, a substituted or non-substituted aryloxy group having 6 to 50 ring-forming carbon atoms, a substituted or non-substituted arylthio group having 6 to 50 ring-forming carbon atoms, a substituted or non-substituted alkoxycarbonyl group having 1 to 50 ring-forming carbon atoms, a substituted or non-substituted aralkyl group having 7 to 31 carbon atoms, a halogen atom, a cyano group, a nitro group, a hydroxyl group or a carboxyl group, and the above respective groups may be combined with each other to form rings; m1 is an integer of 1 to 11, and n1 is an integer of 0 to 10);

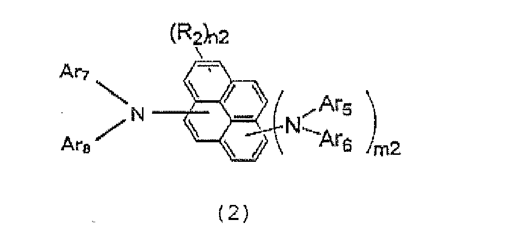

(wherein Ar₅ to Ar₈ each represent independently a substituted or non-substituted aryl group having 6 to 60 ring-forming carbon atoms or a substituted or non-substituted aromatic heterocyclic group having 3 to 40 ring-forming atoms, and Ar₅ to Ar₈ may be the same as or different from each other; R₂ represents a substituted or non-substituted alkyl group having 1 to 50 ring-forming carbon atoms, a substituted or non-substituted aryl group having 6 to 60 ring-forming carbon atoms, a substituted or non-substituted amino group, a substituted or non-substituted silyl group, a substituted or non-substituted ring-forming alkoxy group having 1 to 50 ring-forming carbon atoms, a substituted or non-substituted aryloxy group having 1 to 50 ring-forming carbon atoms, a substituted or non-substituted arylthio group having 5 to 50 ring-forming atoms, a substituted or non-substituted alkoxycarbonyl group having 1 to 50 ring-forming carbon atoms, a substituted or non-substituted aralkyl group having 7 to 31 carbon atoms, a halogen atom, a cyano group, a nitro group, a hydroxyl group or a carboxyl group, and the above respective groups may be combined with each other to form rings; m2 is an integer of 1 to 9, and n2 is an integer of 0 to 8; provided that excluded are a case where m2 is 1, where -NAr₇Ar₈ is bonded to a 2-position (or a 7-position) of the pyrene ring and where -NAr₅Ar₆ is bonded to a 7-position (or a 2-position) of the pyrene ring and a case where m2 is 1, where -NAr₇Ar₈ is bonded to a 4-position (or a 10-position) of the pyrene ring and where -NAr₅Ar₆ is bonded to a 10-position (or a 4-position) of the pyrene ring);

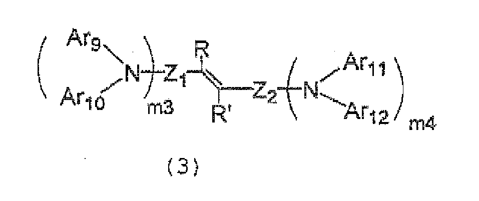

(wherein Ar₉ to Ar₁₂ each represent independently a substituted or non-substituted aryl group having 6 to 60 ring-forming carbon atoms or a substituted or non-substituted aromatic heterocyclic group having 3 to 40 ring-forming atoms, and Ar₉ to Ar₁₂ may be the same as or different from each other; Z₁ and Z₂ each represent independently a substituted or non-substituted aromatic hydrocarbon group having 6 to 60 ring-forming carbon atoms or a substituted or non-substituted aromatic heterocyclic group having 5 to 60 ring-forming atoms; R and R' each represent independently a hydrogen atom, a substituted or non-substituted alkyl group having 1 to 50 ring-forming carbon atoms or a substituted or non-substituted aryl group having 6 to 60 ring-forming carbon atoms; m3 and m4 each are an integer of 0 to 3;
R and R' or Z₁ and Z₂ may be bonded in either a cis position or a trans position based on the double bond in the center, and the compound represented by Formula (3) may be a mixture of a cis body and a trans body);

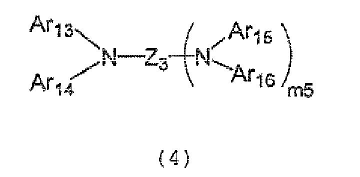

(wherein Ar₁₃ to Ar₁₆ each represent independently a substituted or non-substituted aryl group having 6 to 60 ring-forming carbon atoms or a substituted or non-substituted aromatic heterocyclic group having 3 to 40 ring-forming atoms, and Ar₁₃ to Ar₁₆ may be the same as or different from each other; Z₃ is a substituted or non-substituted aromatic hydrocarbon group having 6 to 60 ring-forming carbon atoms or a substituted or non-substituted aromatic heterocyclic group having 5 to 60 ring-forming atoms; m5 is an integer of 0 to 3; provided that when m5 is 1, excluded is a case where Z₃ is a non-substituted arylene group having 6 to 60 ring-forming carbon atoms and where all of Ar₁₃ to Ar₁₆ are a non-substituted aryl group having 6 to 60 ring-forming carbon atoms);

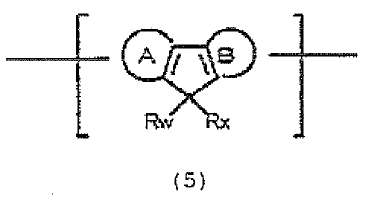

(wherein an A ring and a B ring each represent independently a substituted or non-substituted aryl group having 6 to 60 ring-forming carbon atoms or a substituted or non-substituted aromatic heterocyclic group having 3 to 40 ring-forming atoms; Rw and Rx each represent independently a hydrogen atom, a substituted or non-substituted alkyl group having 1 to 50 ring-forming carbon atoms, a substituted or non-substituted aryl group having 6 to 60 ring-forming carbon atoms, a substituted or non-substituted amino group, a substituted or non-substituted silyl group, a substituted or non-substituted alkoxy group having 1 to 50 ring-forming carbon atoms, a substituted or non-substituted aryloxy group having 6 to 50 ring-forming carbon atoms, a substituted or non-substituted arylthio group having 6 to 50 ring-forming carbon atoms, a substituted or non-substituted alkoxycarbonyl group having 1 to 50 ring-forming carbon atoms, a halogen atom, a cyano group, a nitro group, a hydroxyl group or a carboxyl group, and the above respective groups may be combined with each other to form rings);

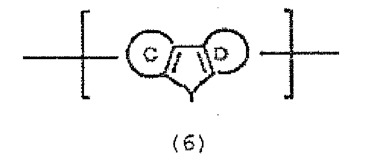

(wherein a C ring and a D ring each represent independently a substituted or non-substituted aryl group having 6 to 60 ring-forming carbon atoms or a substituted or not-substituted aromatic heterocyclic group having 3 to 40 ring-forming atoms; Y represents an oxygen atom, a substituted or non-substituted nitrogen atom, a substituted or non-substituted silicon atom, a substituted or non-substituted phosphorus atom, a sulfur atom, -O-C(Rk)₂- and -N(Rl)-C(Rm)₂-; Rk and Rm represent a hydrogen atom, a substituted or non-substituted alkyl group having 1 to 50 ring-forming carbon atoms, a substituted or non-substituted aryl group having 6 to 60 ring-forming carbon atoms, a substituted or non-substituted amino group, a substituted or non-substituted silyl group, a substituted or non-substituted alkoxy group having 1 to 50 ring-forming carbon atoms, a substituted or non-substituted aryloxy group having 6 to 50 ring-forming carbon atoms, a substituted or non-substituted arylthio group having 6 to 50 ring-forming carbon atoms, a substituted or non-substituted alkoxycarbonyl group having 1 to 50 ring-forming carbon atoms, a halogen atom, a cyano group, a nitro group, a hydroxyl group or a carboxyl group, and the above respective groups may be combined with each other to form rings; each two groups of Rk and Rm may be the same as or different from each other; and Rl represents a hydrogen atom, a substituted or non-substituted alkyl group having 1 to 50 ring-forming carbon atoms or a substituted or non-substituted aryl group having 6 to 60 ring-forming carbon atoms).

(2) A material for organic EL containing the high polymer compound according to the above item (1).
(3) An organic EL device comprising an anode, a cathode and an organic compound layer comprising at least one layer interposed between the anode and the cathode, wherein at least one layer of the above organic compound layers is a light emitting layer, and the organic compound layer contains the material for organic EL according to the above item (2).
(4) A solution containing the high polymer compound according to the above item (1).
(5) A method for forming a thin film in which a film is formed from the solution according to the above item (4) by an ink jet method.

The high polymer compound of the present invention is useful as a light emitting material and can provide an organic EL device which is excellent in device characteristics such as a lifetime, a luminous efficiency and the like.

### BEST MODE FOR CARRYING OUT THE INVENTION

The high polymer compound of the present invention present invention comprises at least one repeating unit A selected from divalent groups derived from compounds represented by the following Formulas (1) to (4) and at least one repeating unit B selected from the following Formulas (5) and (6).
Formula (1) shall be explained below.

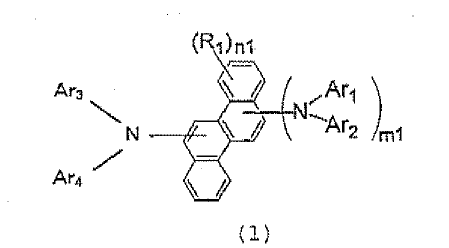

In Formula (1), Ar₁ to Ar₄ each represent independently a substituted or non-substituted aryl group having 6 to 60, preferably 6 to 40 and more preferably 6 to 20 ring-forming carbon atoms or a substituted or non-substituted aromatic heterocyclic group having 3 to 40, preferably 3 to 20 ring-forming atoms, and Ar₁ to Ar₄ may be the same as or different from each other.

The substituted or non-substituted aryl group in Ar₁ to Ar₄ includes, for example, phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, biphenylyl-2-yl, biphenylyl-3-yl, biphenylyl-4-yl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl-4-yl, 4"-t-buryl-p-terphenyl-4-yl and the like, and phenyl, 1-naphthyl and 2-naphthyl are preferred.

The substituted or non-substituted aromatic heterocyclic group in Ar₁ to Ar₄ includes, for example, 1-pyrrolyl, 2-pyrrolyl, 3-pyrrolyl, pyrazinyl, 2-pyridinyl, 3-pyridinyl, 4-pyridinyl, 1-indolyl, 2-indolyl, 3-indolyl, 4-indolyl, 5-indolyl, 6-indolyl, 7-indolyl, 1-isoindolyl, 2-isoindolyl, 3-isoindolyl, 4-isoindolyl, 5-isoindolyl, 6-isoindolyl, 7-isoindolyl, 2-furyl, 3-furyl, 2-benzofuranyl, 3-benxofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, 2-quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-carbazolyl, 2-carbazolyl, 3-carbazolyl, 4-carbazolyl, 9-carbazolyl, 1-phenanthridinyl, 2-phenanthridinyl, 3-phenanthridinyl, 4-phenanthridinyl, 6-phenanthridinyl, 7-phenanthridinyl, 8-phenanthridinyl, 9-phenanthridinyl, 10-phenanthryldinyl, 1-acridinyl, 2-acridinyl, 3-acridinyl, 4-acridinyl, 9-acridinyl, 1,7-phenanthroline-2-yl, 1,7-phenanthroline-3-yl, 1,7-phenanthroline-4-yl, 1,7-phenanthroline-5-yl, 1,7-phenanthroline-6-yl, 1,7-phenanthroline-8-yl, 1,7-phenanthroline-9-yl, 1,7-phenanthroline-10-yl, 1,8-phonanthloline-2-yl, 1,8-phenanthroline-3-yl, 1,8-phenanthroline-4-yl, 1,8-phenanthroline-5-yl, 1,8-phenanthroline-6-yl, 1,8-phenanthroline-7-yl, 1,8-phenanthroline-9-yl, 1,8-phenanthroline-10-yl, 1,9-phenanthroline-2-yl, 1,9-phenanthroline-3-yl, 1,9-phenanthroline-4-yl, 1,9-phenanthroline-5-yl, 1,9-phenanthroline-6-yl, 1,9-phenanthroline-7-yl, 1,9-phenanthroline-8-yl, 1,9-phenanthroline-10-yl, 1,10-phenanthroline-2-yl, 1,10-phenanthroline-3-yl, 1,10-phenanthroline-4-yl, 1,10-phenanthroline-5-yl, 2,9-phenanthroline-1-yl, 2,9-phenanthroline-3-yl, 2,9-phenanthroline-4-yl, 2,9-phenanthroline-5-yl, 2,9-phenanthroline-6-yl, 2,9-phenanthroline-7-yl, 2,9-phenanthroline-8-yl, 2,9-phenanthroline-10-yl, 2,8-phenanthrolirte-1-yl, 2,8-phenanthroline-3-yl, 2,8-phenanthroline-4-yl, 2,8-phenanthroline-5-yl, 2,8-phenanthroline-6-yl, 2,8-phenanthroline-7-yl, 2,8-phenanthroline-9-yl, 2,8-phenanthroline-10-yl, 2,7-phenanthroline-1-yl, 2,7-phenanthroline-3-yl, 2,7-phenanthroline-4-yl, 2,7-phenanthroline-5-yl, 2,7-phenanthroline-6-yl, 2,7-phenanthroline-8-yl, 2,7-phenanthroline-9-yl, 2,7-phenanthroline-10-yl, 1-phenazinyl, 2-phenazinyl, 1-phenothiazinyl, 2-phenothiazinyl, 3-phenothiazinyl, 4-phenothiazinyl, 10-phenothiazinyl, 1-phenoxazinyl, 2-phenoxazinyl, 3-phenoxazinyl, 4-phenoxazinyl, 10-phenoxazinyl, 2-oxazolyl, 4-oxazolyl, 5-oxazolyl, 2-oxadiazolyl, 5-oxadiazolyl, 3-furazanyl, 2-thienyl, 3-thienyl, 2-methylpyrrole-l-yl, 2-methylpyrrole-3-yl, 2-methylpyrrole-4-yl, 2-methylpyrrole-5-yl, 3-methylpyrrole-1-yl, 3-methylpyrrole-2-yl, 3-methylpyrrole-4-yl, 3-methylpyrrole-5-yl, 2-t-butylpyrrole-4-yl, 3-(2-phenylpropyl)pyrrole-1-yl, 2-methyl-1-indolyl, 4-methyl-1-indolyl, 2-methyl-3-indolyl, 4-methyl-3-indolyl, 2-t-butyl-1-indolyl, 4-t-butyl-1-indolyl, 2-t-butyl-3-indolyl, 4-t-butyl-3-indolyl, 5-methylthienyl, 2-dibenzofuranyl, 4-dibenzofuranyl and the like.
Among them, preferred are 2-pyridinyl, 4-pyridinyl, 1-indolyl, 4-indolyl, 5-indolyl, 6-indolyl, 7-indolyl, 2-quinolyl, 3-quinolyl, 5-quinolyl, 6-quinolyl, 1-isoquinolyl, 4-isoquinolyl, 5-isoquinolyl, 8-isoquinolyl, 3-carbazolyl, 9-carbazolyl, 1,10-phenanthroline-3-yl, 1,10-phenanthroine-5-yl, 4-methyl-1-indolyl, 5-methylthienyl, 2-dibenzofuranyl and 4-dibensofuranyl.

In Formula (1), R₁ represents a substituted or non-substituted alkyl group having 1 to 50 ring-forming carbon atoms, a substituted or non-substituted aryl group having 6 to 60 ring-forming carbon atoms, a substituted or noun-substituted amino group, a substituted or non-substituted silyl group, a substituted or non-substituted alkoxy group having 1 to 50 ring-forming carbon atoms, a substituted or noun-substituted aryloxy group having 6 to 50 ring-forming carbon atoms, a substituted or non-substituted arylthio group having 6 to 50 ring-forming carbon atoms, a substituted or non-substituted alkoxycarbonyl group having 1 to 50 ring-forming carbon atoms, a substituted or non-substituted aralkyl group having 7 to 31 carbon atoms (an aryl part has 6 to 30 carbon atoms), a halogen atom, a cyano group, a nitro group, a hydroxyl group or a carboxyl group, and the above respective groups may be combined with each other to form rings.
Among them, preferred are a substituted or non-substituted alkyl group having 1 to 10 ring-forming carbon atoms, a substituted or non-substituted aryl group having 6 to 20 ring-forming carbon atoms, a substituted or non-substituted amino group, a substituted or non-substituted silyl group, a substituted or non-substituted alkoxy group having 1 to 10 ring-forming carbon atoms, a substituted or non-substituted aryloxy group having 6 to 20 ring-forming carbon atoms and a cyano group.
The carbon atoms and the atomic numbers of the respective groups are numbers which do not include those of the substituents.

The substituted or non-substituted alkyl group represented by R₁ includes, for example, methyl, ethyl, propyl, isopropyl, butyl, s-butyl, t-butyl, pentyl, hexyl, heptyl, octyl, stearyl, trichloromethyl, trifluoromethyl, cyclopentyl, cyclohexyl and the like, and methyl, ethyl, propel, isopropyl, butyl, s-butyl, t-butyl, cyclopentyl and cyclohexyl are preferred.
The substituted or non-substituted aryl group represented by R₁ includes, for example phony, 2-methylphenyl, 3-methylphenyl, 4-methylphenyl, 4-ethylphenyl, biphenyl, 4-methybiphenyl, 4-ethylbiphenyl, 4-cyclohexylbiphenyl, terphenyl, 3,5-dichlorophenyl, naphthyl, 5-methylnaphthyl, anthryl, pyrenyl and the like, and phenyl, 3-methylphenyl, 4-methylphenyl, biphenyl and naphthyl are preferred.
The substituted or non-substituted amino group represented by R₁ includes a mono- or dialkylamino group having an alkyl group having 1 to 20 carbon atoms, a mono- or diarylamino group having an aryl group having 6 to 30 ring-forming-carbon atoms and the like, and it includes, to be specific, amino groups substituted with the alkyl groups or the aryl groups described above.
The substituted or non-substituted silyl group represented by R₁ includes trimethylsilyl, triethylsilyl, t-butyldimethylsilyl, vinyldimethylsilyl, propyldimethylsilyl, triphenylsilyl and the like, and trimethylsilyl, triethylsilyl and t-butyldimethylsilyl are preferred.
The substituted or non-substituted alkoxy group represented by R₁ includes, for example, methoxy, ethoxy, propoxy, isopropoxy, butoxy, isobutoxy, s-butoxy, t-butoxy, pentyloxy (including the isomers), hexyloxy (including the isomers), phenoxy and the like, and methoxy, ethoxy, propoxy and isopropoxy are preferred.
The substituted or non-substituted aryloxy group and arylthio group represented by R₁ are represented by -OX and -SX respectively, and the examples of X include the same examples as those of the substituted or non-substituted aryl group represented by R₁.
The substituted or non-substituted alkoxycarbonyl group represented by R₁ is represented by -COOZ respectively, and the examples of Z include the same examples as those of the substituted or non-substituted alkyl group represented by R₁.

The substituted or non-substituted aralkyl group represented by R₁ includes, for example, benzyl, 1-phenylethyl, 2-phenylethyl, 1-phenylizopzopyl, 2-phenylisopropyl, phenyl-t-butyl, α-naphthylmethyl, 1-α-naphthylethyl, 2-α-naphthylethyl, 1-α-naphthylisopropyl, 2-α-naphthylisopropyl, β-naphthylmethyl, 1-β-naphthylethyl, 2-β-naphthylethyl, 1-β-naphthylisopropyl, 2-β-naphthylisopropyl, 1-pyrrolylmethyl, 2-(1-pyrrolyl)ethyl, p-methylbenzyl, m-methylbenzyl, o-methylbenzyl, p-chlorobenzyl, m-chlorobenzyl, o-chlorobenzyl, p-bromobenzyl, m-bromobenzyl, o-bromobenzyl, p-iodobenzyl, m-iodobenzyl, o-iodobenzyl, p-hydroxybenzyl, m-hydroxybenzyl, o-hydroxybenzyl, p-aminobenzyl, m-aminobenzyl, o-aminobenzyl, p-nitrobenzyl, m-nitrobenzyl, o-nitrobenzyl, p-cyanobenzyl, m-cyanobenzyl, o-cyanobenzyl, α-phenoxybenzyl, α,α-dimethylbenzyl, α,α-phenylmethylbenzyl, α,α-ditrifluoromethylbenzyl, triphenylmethylbenzyl, α-benzyloxybenzyl, 1-hydroxy-2-phenylisopropyl, 1-chloro-2-phenylisopropyl and the like.

In Formula (1), ml is 1 to 11, preferably 1 to 3 and more preferably 1. Also, n1 is 0 to 10.
In Formula (1), a valency of at least 1 is present preferably in chrysene in the center.
Substituents for the substituted or non-substituted groups in Ar₁ to Ar₄ include the same groups as in R₁ described above.
The compound represented by Formula (1) is preferably a compound represented by the following Formula (1-a):

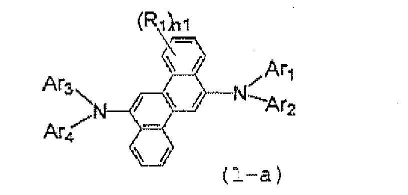

In Formula (1-a), Ar₁ to Ar₄, R₁ and n1 each are the same as described above.
The specific examples of the compound represented by Formula (1) include the following compounds:

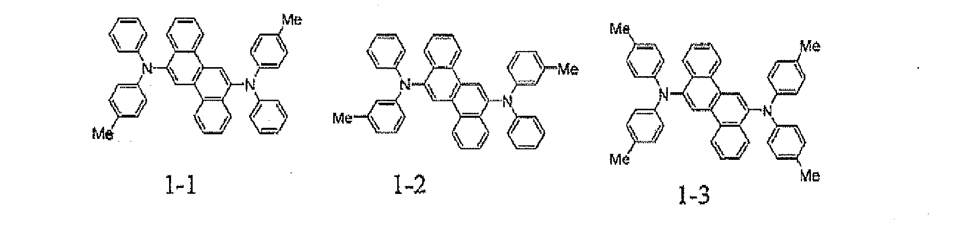

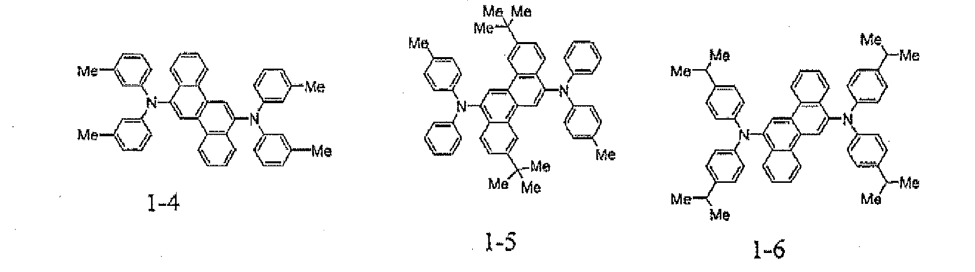

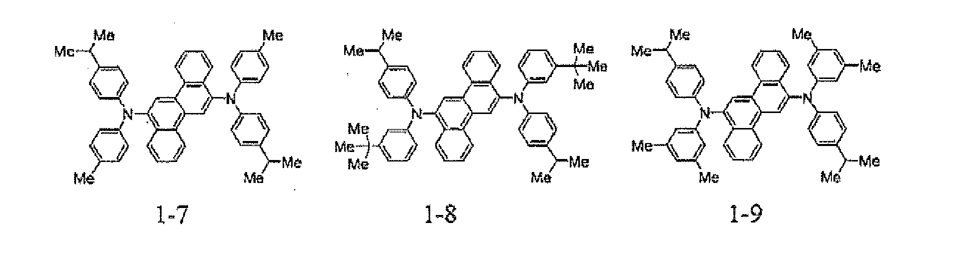

Formula (2) shall be explained below:

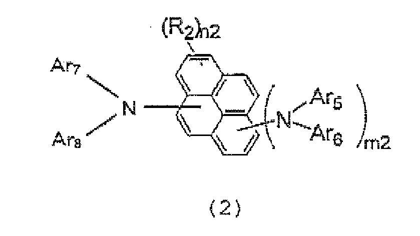

In Formula (2), Ar₅ to Ar₈ each represent independently a substituted or non-substituted aryl group having 6 to 60 ring-forming carbon atoms or a substituted or non-substituted aromatic heterocyclic group having 3 to 40 ring-forming atoms, and Ar₅ to Ar₈ may be the same as or different from each other.
The specific examples of the above respective groups and the preferred groups thereof include the same groups as in Ar₁ to Ar₄ of Formula (1) described above.
In Formula (2), R₂ represents a substituted or non-substituted alkyl group having 1 to 50 ring-forming carbon atoms, a substituted or non-substituted aryl group having 6 to 60 ring-forming carbon atoms, a substituted or non-substituted amino group, a substituted or non-substituted silyl group, a substituted or non-substituted alkoxy group having 1 to 50 ring-forming carbon atoms, a substituted or non-substituted aryloxy group having 1 to 50 ring-forming carbon atoms, a substituted or non-substituted arylthio group having 5 to 50 ring-forming atoms, a substituted or non-substituted alkoxycarbonyl group having 1 to 50 ring-forming carbon atoms, a halogen atom, a cyano group, a nitro group, a hydroxyl group or a carboxyl group, and the above respective groups may be combined with each other to form rings.
The specific examples of the above respective groups and the preferred groups thereof include the same groups as in R₁ of Formula (1) described above.
In Formula (2), m2 is 1 to 9, preferably 1 to 3 and more preferably 1. Also, n2 is 0 to 8.
In Formula (2), a valency of at least 1 is present preferably in pyrene in the center.
Provided that in Formula (2), excluded are a case where m2 is 1, where -NAr₇Ar₈ is bonded to a 2-position (or a 7-position) of the pyrene ring and where -NAr₅Ar₆ is bonded to a 7-position (or a 2-position) of the pyrene ring and a case where m2 is 1, where -NAr₇Ar₈ is bonded to a 4-position (or a 10-position) of the pyrene ring and where -NAr₅Ar₆ is bonded to a 10-position (or a 4-position) of the pyrene ring.
Substituents for the substituted or non-substituted groups in Ar₅ to Ar₈ include the same groups as in R₁ described above.

The compound represented by Formula (2) is preferably a compound represented by the following Formula (2-a) or (2-b): 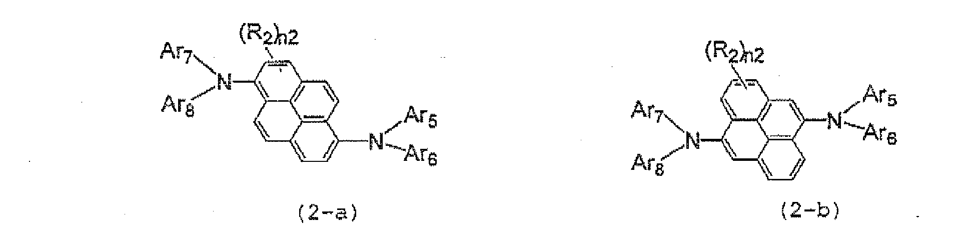 In Formulas (2-a) and (2-b), Ar₅ to Ar₈, R₂ and n2 each are the same as described above.

In Formulas (2), (2-a) and (2-b), R₂ is bonded preferably to the 3-position and the 8-position. Further, in Formulas (2), (2-a) and (2-b), R₂ is preferably an alkyl group or a substituted or non-substituted aryl group having 6 to 60 ring-forming carbon atoms.
The specific examples of the compound represented by Formula (2) include the following compounds:

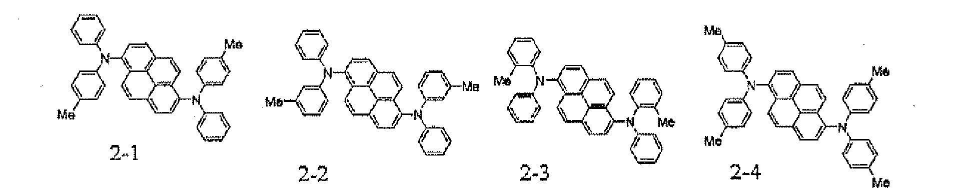

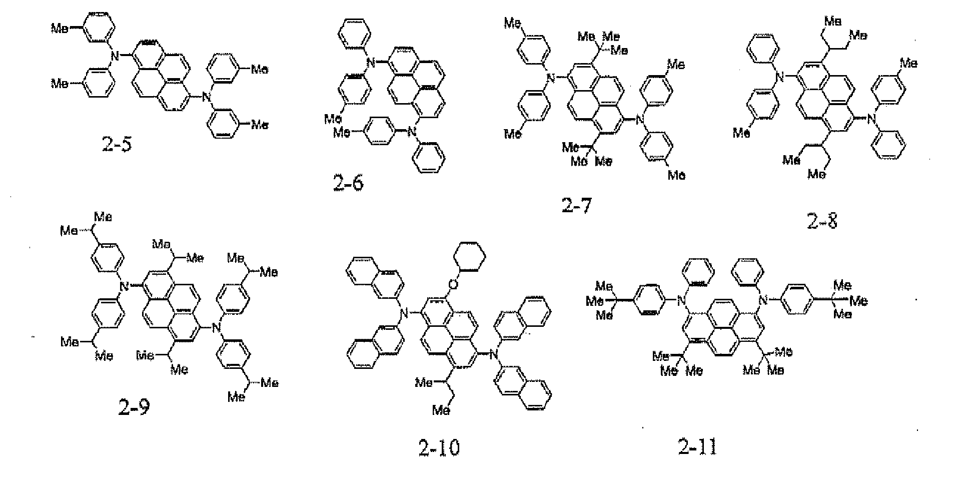

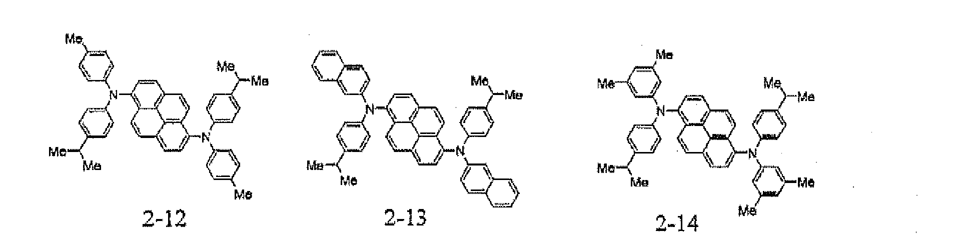

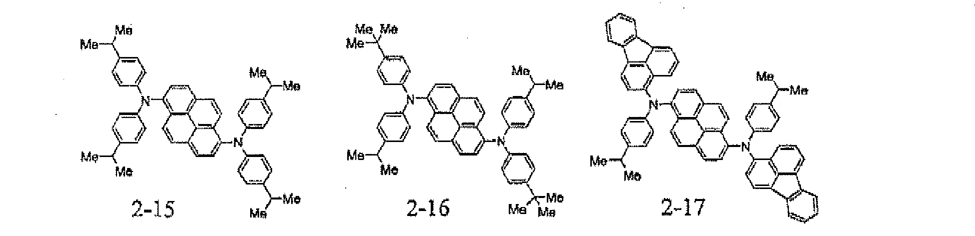

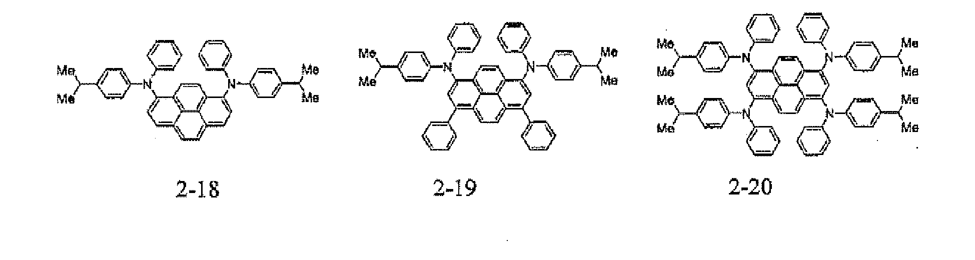

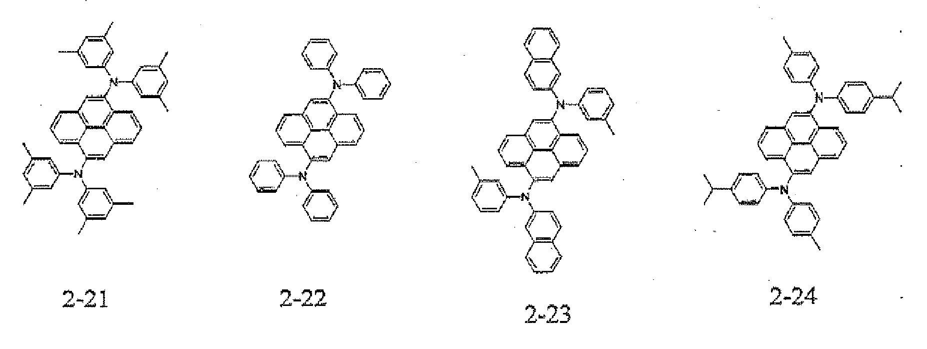

Formula (3) shall be explained below:

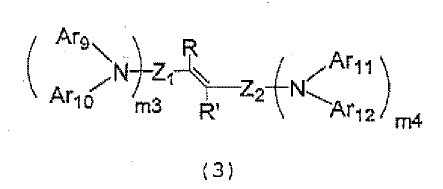

In Formula (3), Ar₉ to Ar₁₂ each represent independently a substituted or non-substituted aryl group having 6 to 60 ring-forming carbon atoms or a substituted or non-substituted aromatic heterocyclic group having 3 to 40 ring-forming atoms, and Ar₉ to Ar₁₂ may be the same as or different from each other.
The specific examples of the above respective groups and the preferred groups include the same groups as in Ar₁ and Ar₂ of Formula (1) described above.
In Formula (3), Z₁ and Z₂ each represent independently a substituted or non-substituted aromatic hydrocarbon group having 6 to 60 ring-forming carbon atoms or a substituted or non-substituted aromatic heterocyclic group having 5 to 60 ring-forming atoms.
The specific examples of the aromatic hydrocarbon group include examples obtained by converting the aryl groups represented by Ar₁ to Ar₄ in Formula (1) described above into mono- to tetravalent groups, and the specific examples of the aromatic heterocyclic group include groups which meet atomic numbers thereof among examples obtained by converting the aromatic heterocyclic groups represented by Ar₁ to Ar₄ into mono- to tetravalent groups.
In Formula (3), R and R' each represent independently a hydrogen atom, a substituted or non-substituted alkyl group having 1 to 50 ring-forming carbon atoms or a substituted or non-substituted ring-forming aryl group having 6 to 60 carbon atoms, and the specific examples of the above respective groups and the preferred groups thereof include the same groups as in R₁ of Formula (1) described above.
In Formula (3), m3 and m4 each are 0 to 3, preferably 1.
In Formula (3), a valency of at least 1 is present preferably in Z₁ or Z₂ in the center.
In Formula (3), R and R' or Z₁ and Z₂ may be bonded in either a cis position or a trans position based on the double bond in the center, and the compound represented by Formula (3) may be a mixture of a cis body and a trans body.
Substituents for the substituted or noun-substituted groups in Ar₉ to Ar₁₂ include the same groups as in R₁ described above.

The compound represented by Formula (3) is preferably a compound represented by the following Formula (3-a) :

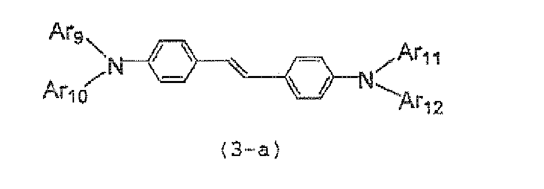

In Formula (3-a), Ar₉ to Ar₁₂ each are independently the same as described above. Provided that all of Ar₉ to Ar₁₂ show the same group.
The specific examples of the compound represented by Formula (3) include the following compounds:

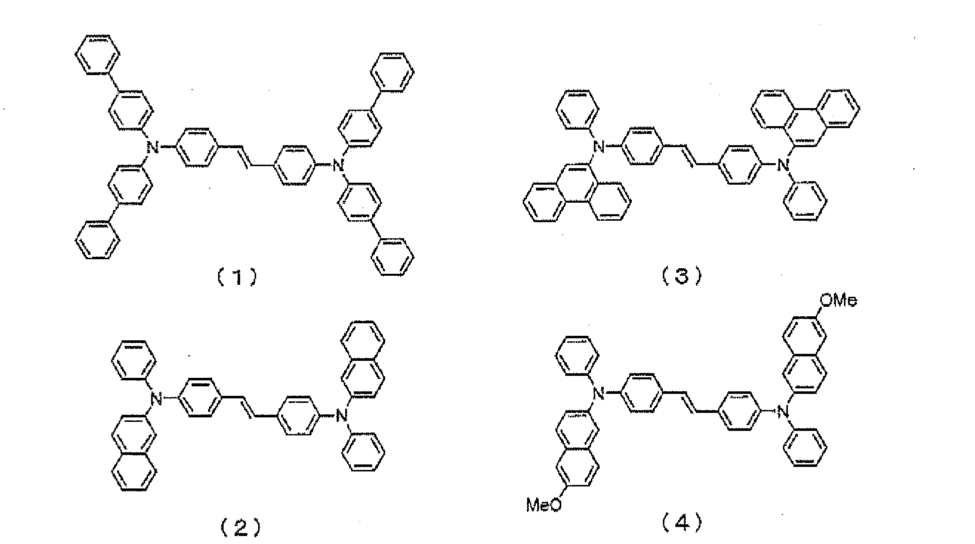

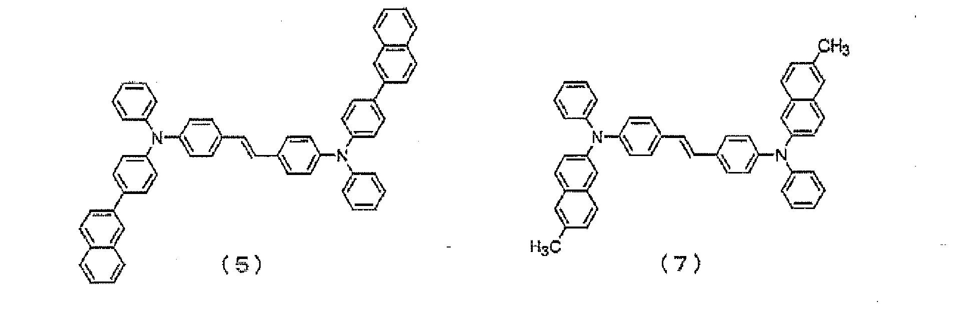

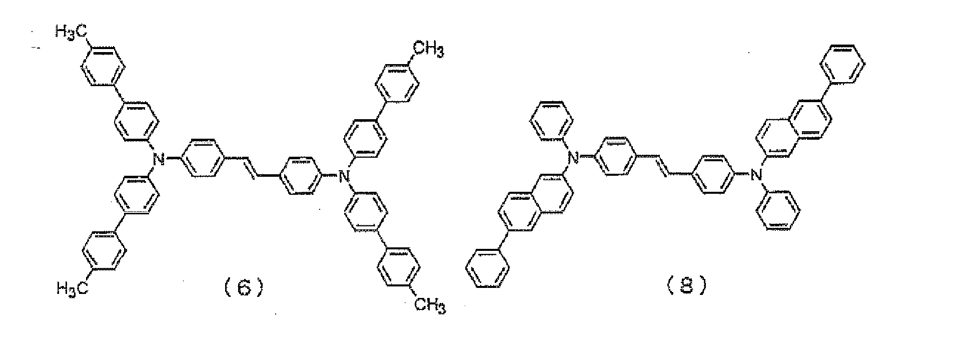

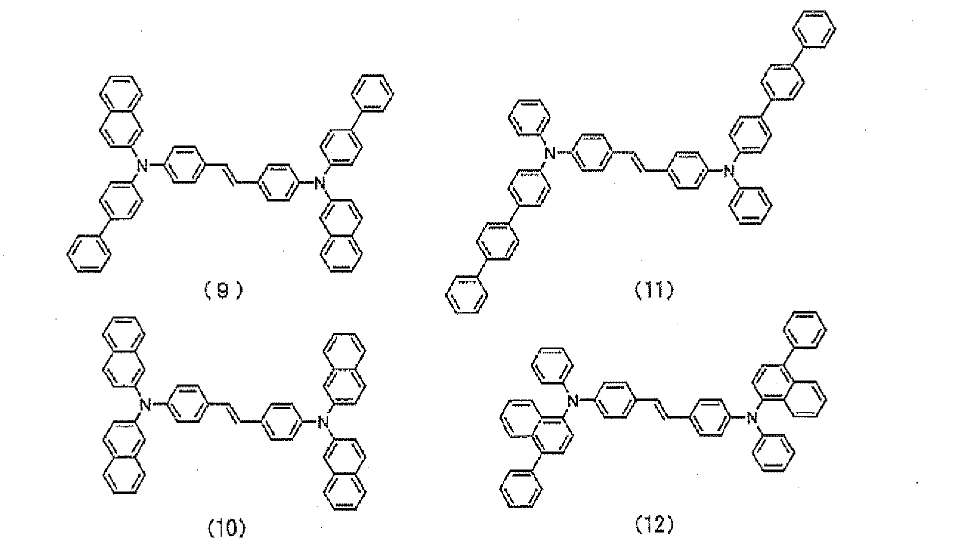

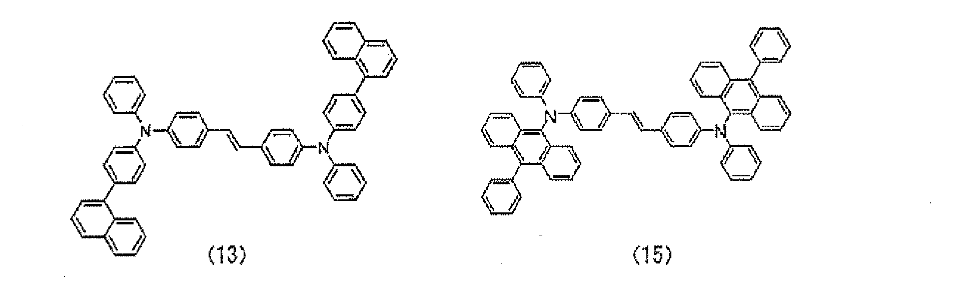

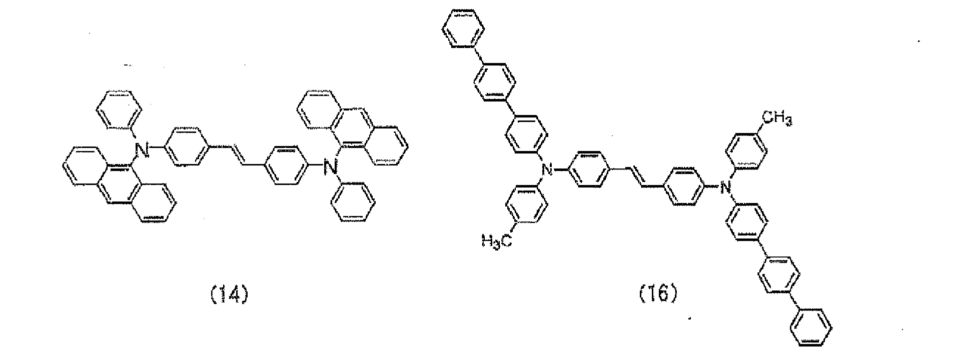

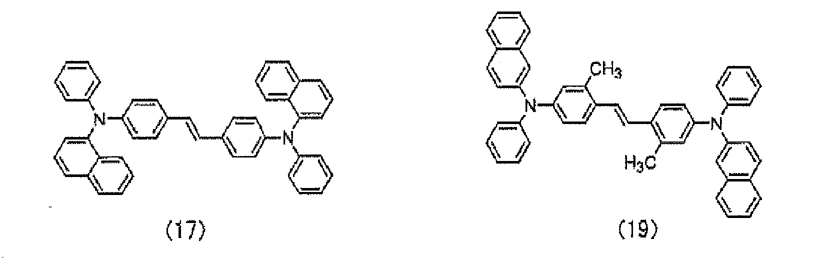

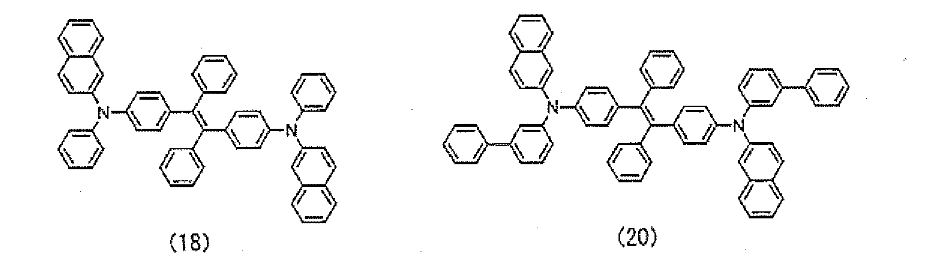

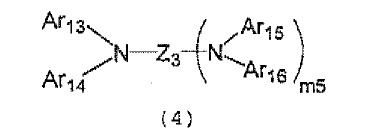

In Formula (4), Ar₁₃ to Ar₁₆ each represent independently a substituted or non-substituted aryl group having 6 to 60 ring-forming carbon atoms or a substituted or non-substituted aromatic heterocyclic group having 3 to 40 ring-forming atoms, and Ar₁₃ to Ar₁₆ may be the same as or different from each other.
The specific examples of the above respective examples and the preferred groups thereof include the same groups as in Ar₁ to Ar₄ of Formula (1) described above.
In Formula (4), Z₃ is a substituted or non-substituted aromatic hydrocarbon group having 6 to 60 ring-forming carbon atoms or a substituted or non-substituted aromatic heterocyclic group having 5 to 60 ring-forming atoms.
The specific examples of the aromatic hydrocarbon group include examples obtained by converting the aryl groups represented by Ar₁ to Ar₄ in Formula (1) described above into mono- to tetravalent groups, and the specific examples of the aromatic heterocyclic group include groups which meet atomic numbers thereof among examples obtained by converting the aromatic heterocyclic groups represented by Ar₁ to Ar₄ into mono- to tetravalent groups.
In Formula (4), m5 is 0 to 3, preferably 1.
In Formula (4), a valency of at least 1 is present preferably in Z₃ in the center.
Provided that when m5 is 1 in Formula (4), excluded is a case where Z₃ is a non-substituted arylene group having 6 to 60 ring-forming carbon atoms and where all of Ar₁₃ to Ar₁₆ are a non-substituted aryl group having 6 to 60 ring-forming carbon atoms.
Substituents for the substituted or non-substituted groups in Ar₁₃ to Ar₁₆ include the same groups as in R₁ described above.

The compound represented by Formula (4) is preferably a compound represented by the following Formula (4-a): 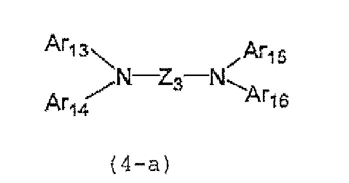 In Formulas (4-a), Ar₁₃ to Ar₁₆ and Z₃ each are independently the same as described above. Provided that a valency of at least 1 is present preferably in Z₃ in the center and that a valency of 1 or 2 is present preferably in Z₃.
The specific examples of the compound represented by Formula (4) include the following compounds:

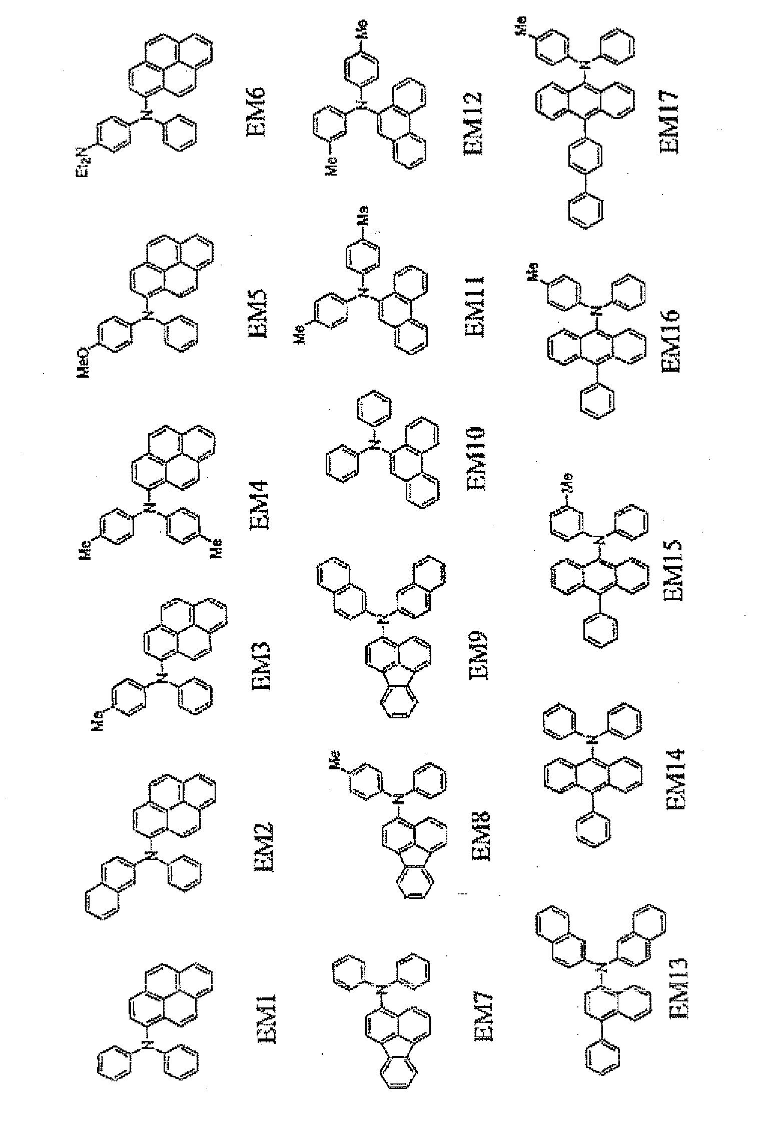

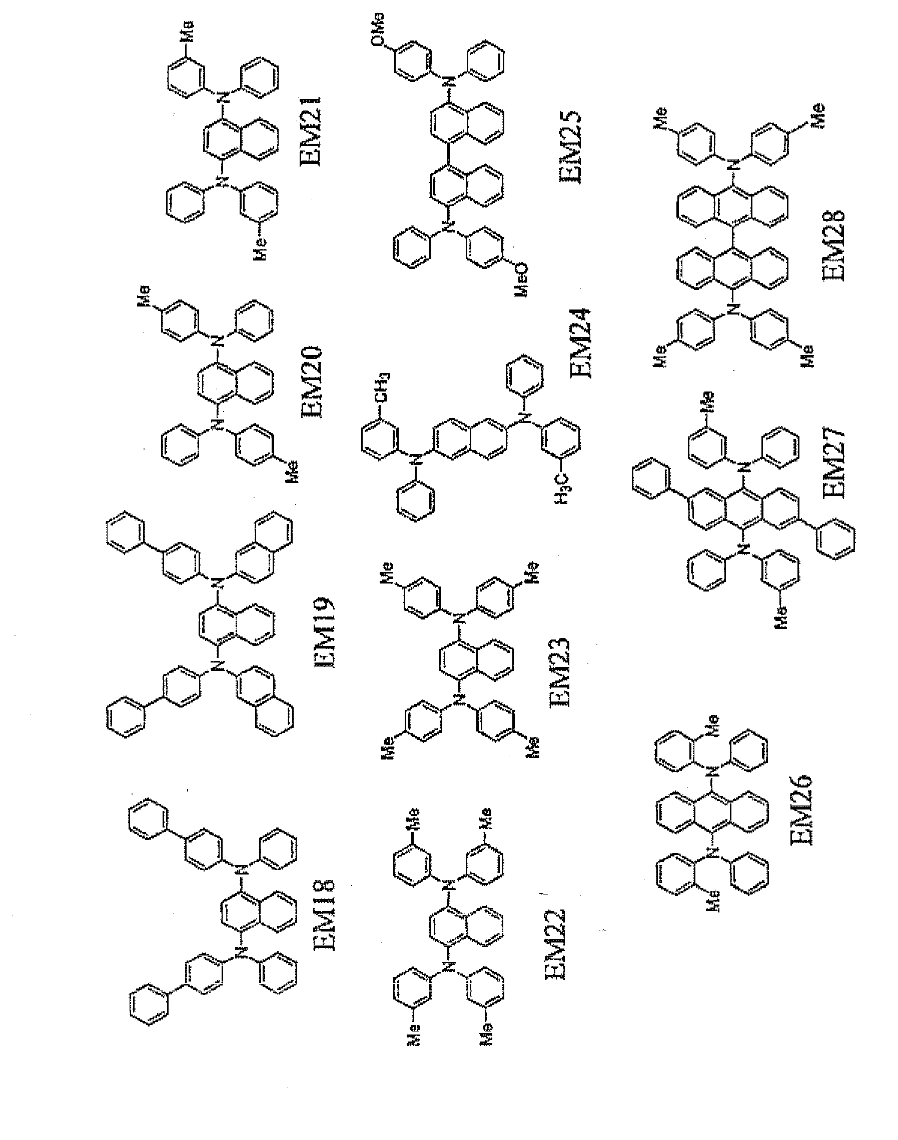

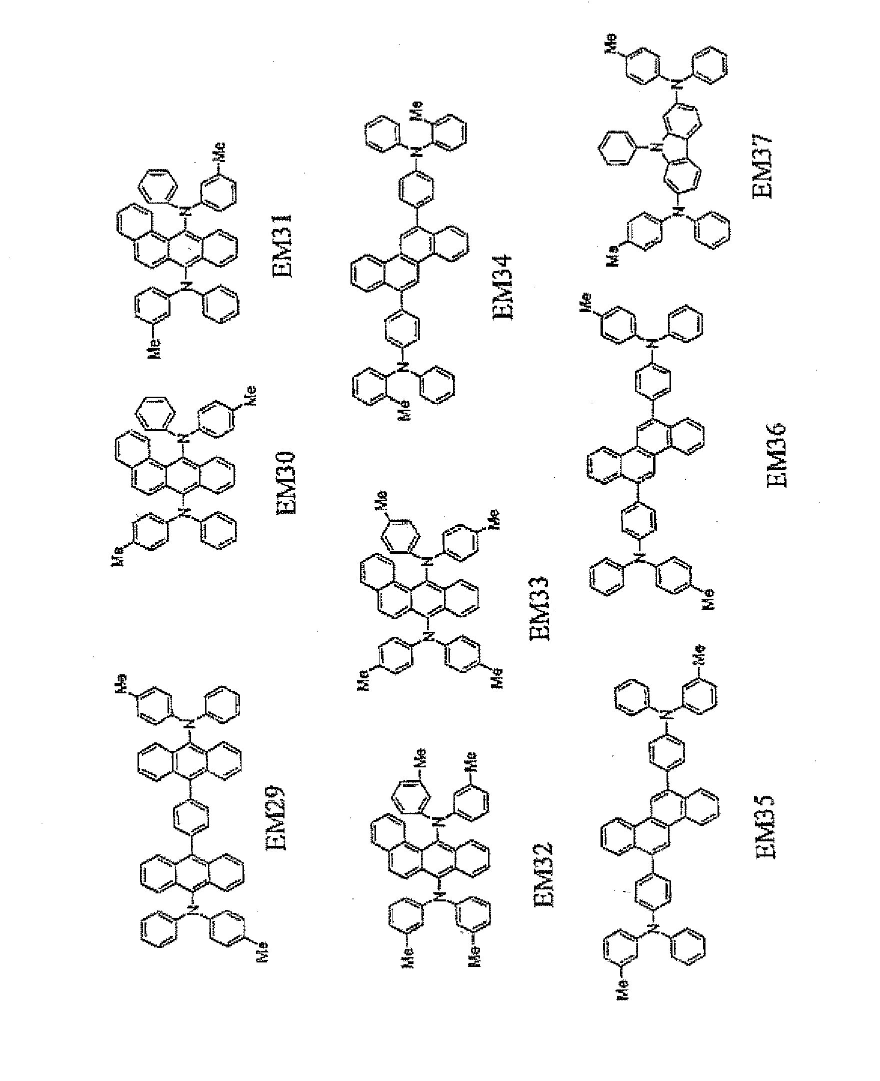

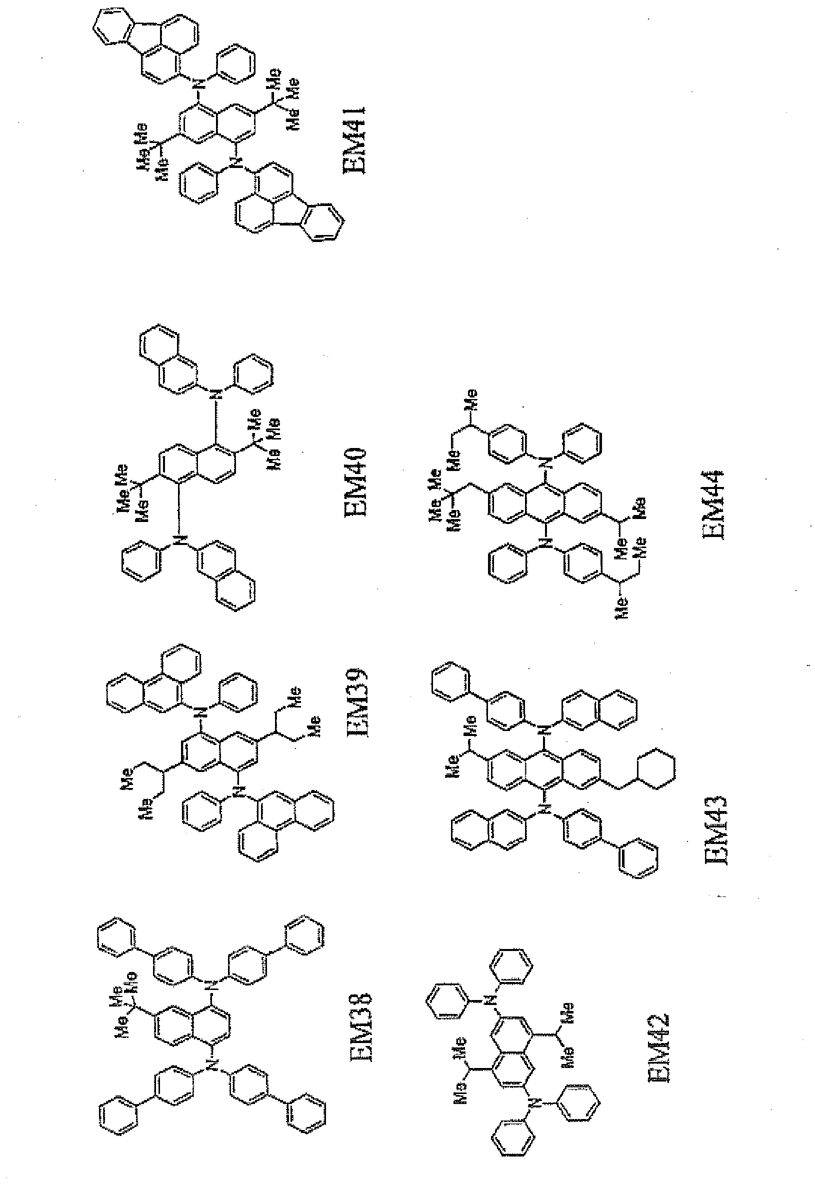

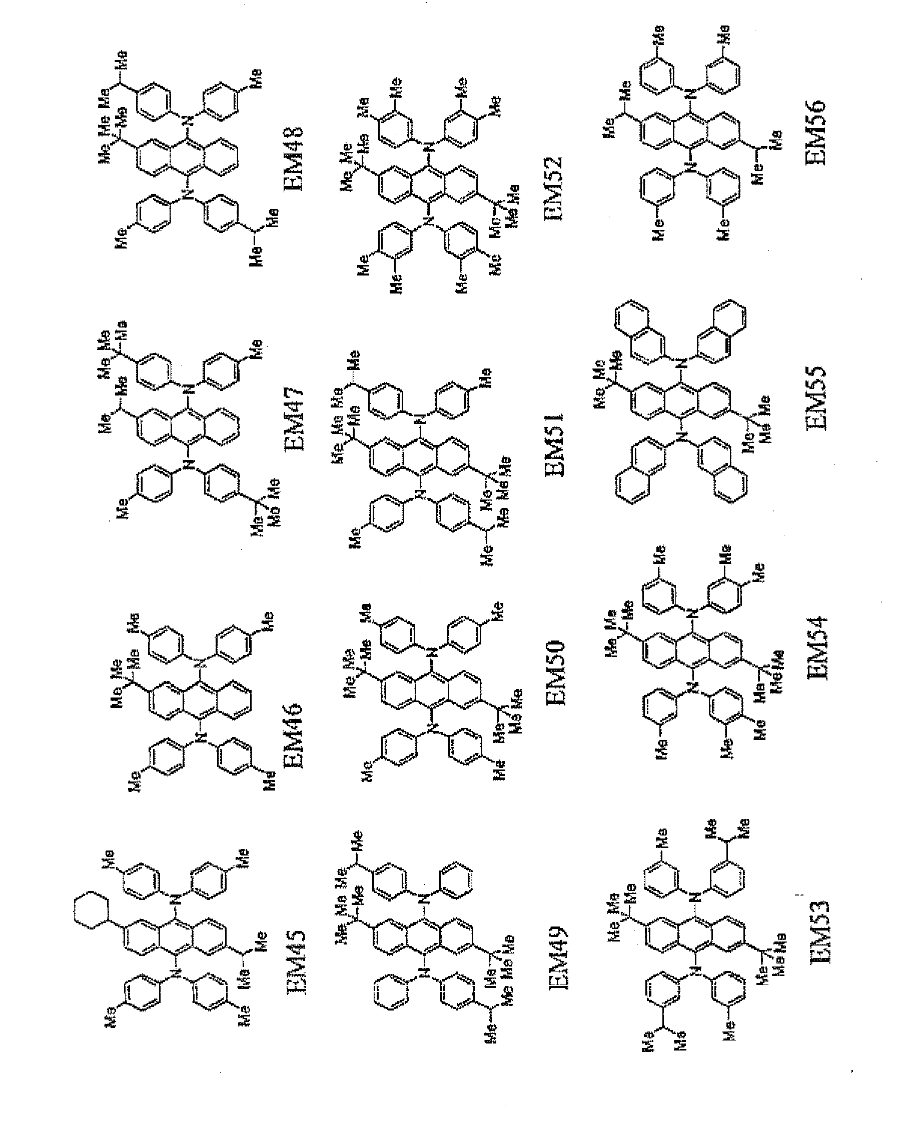

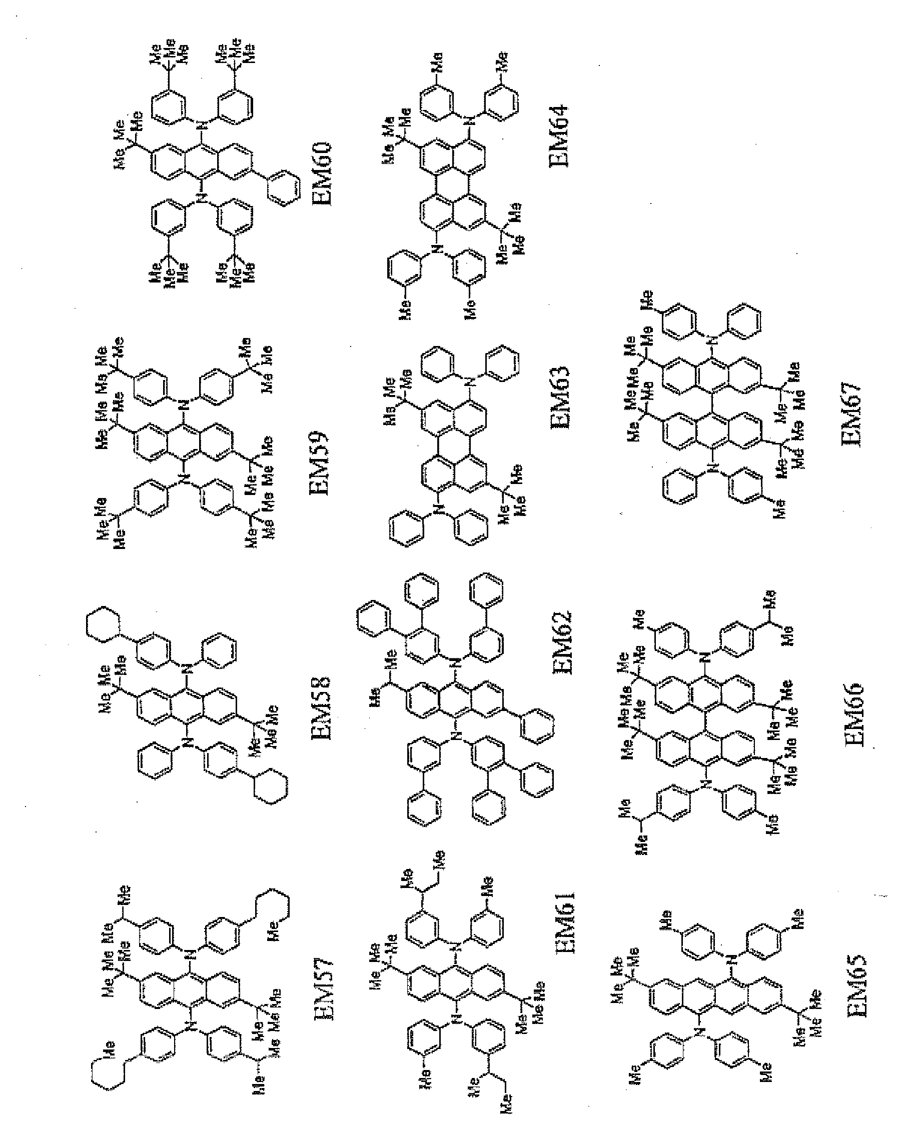

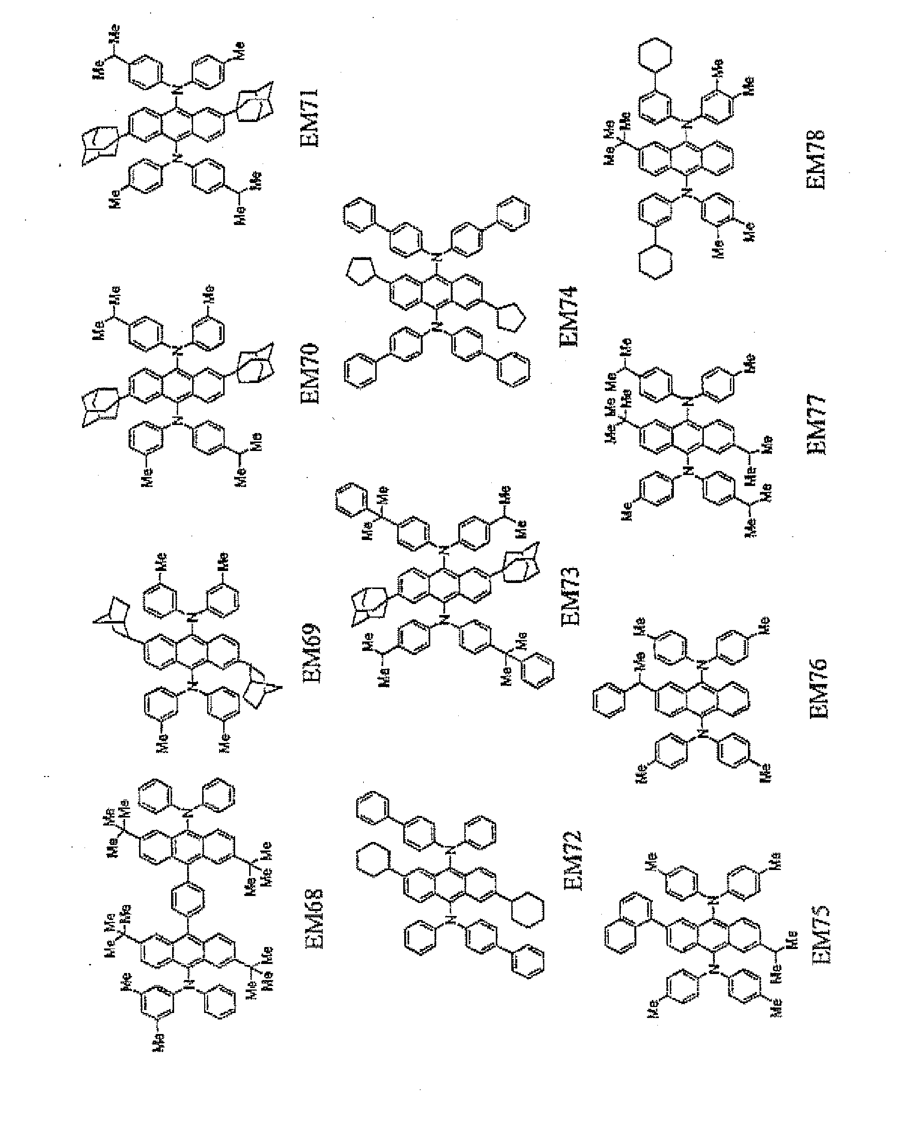

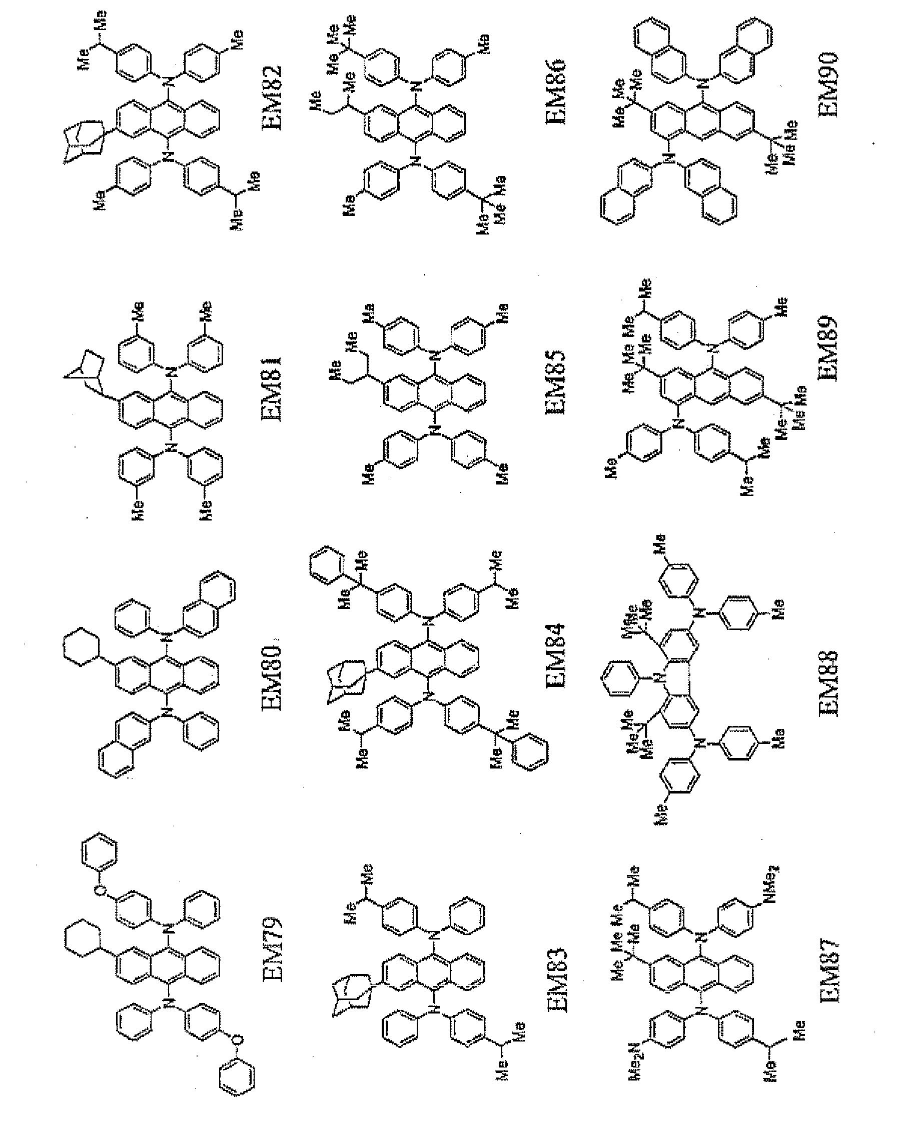

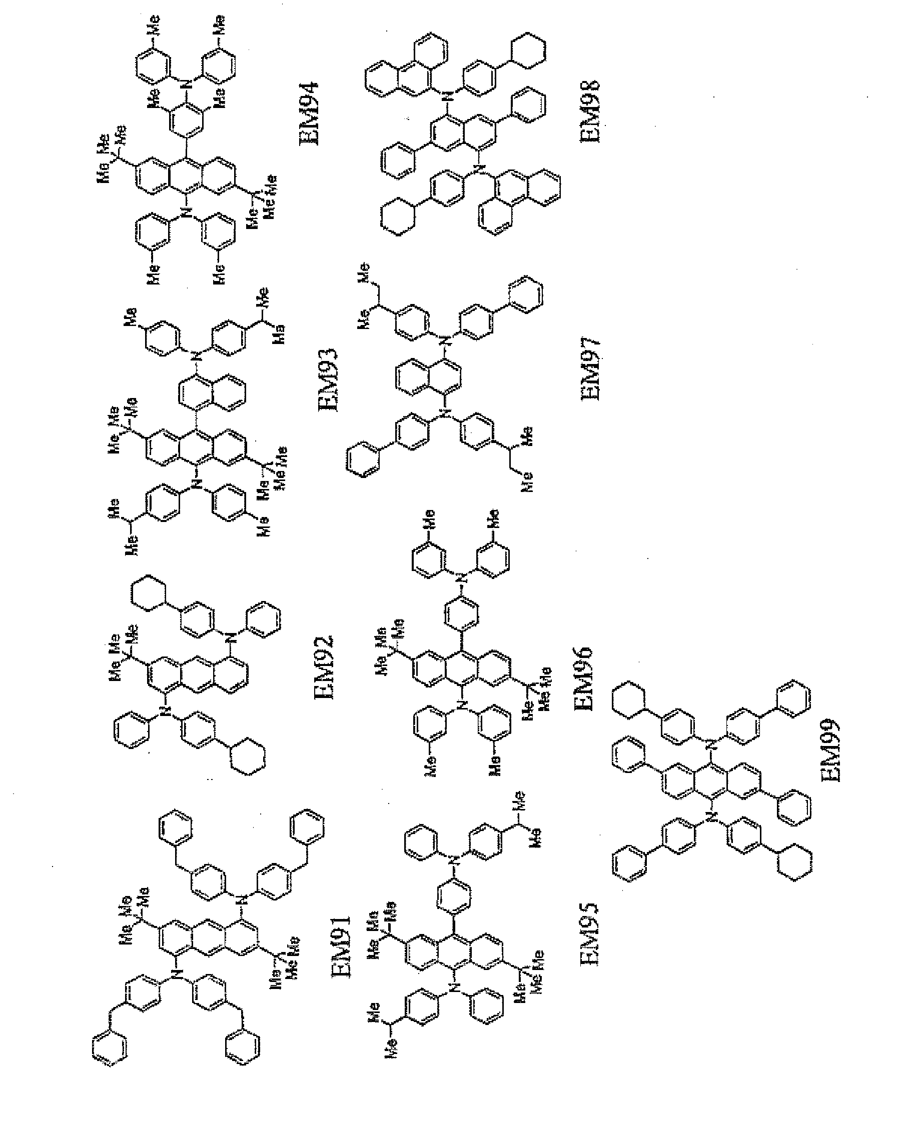

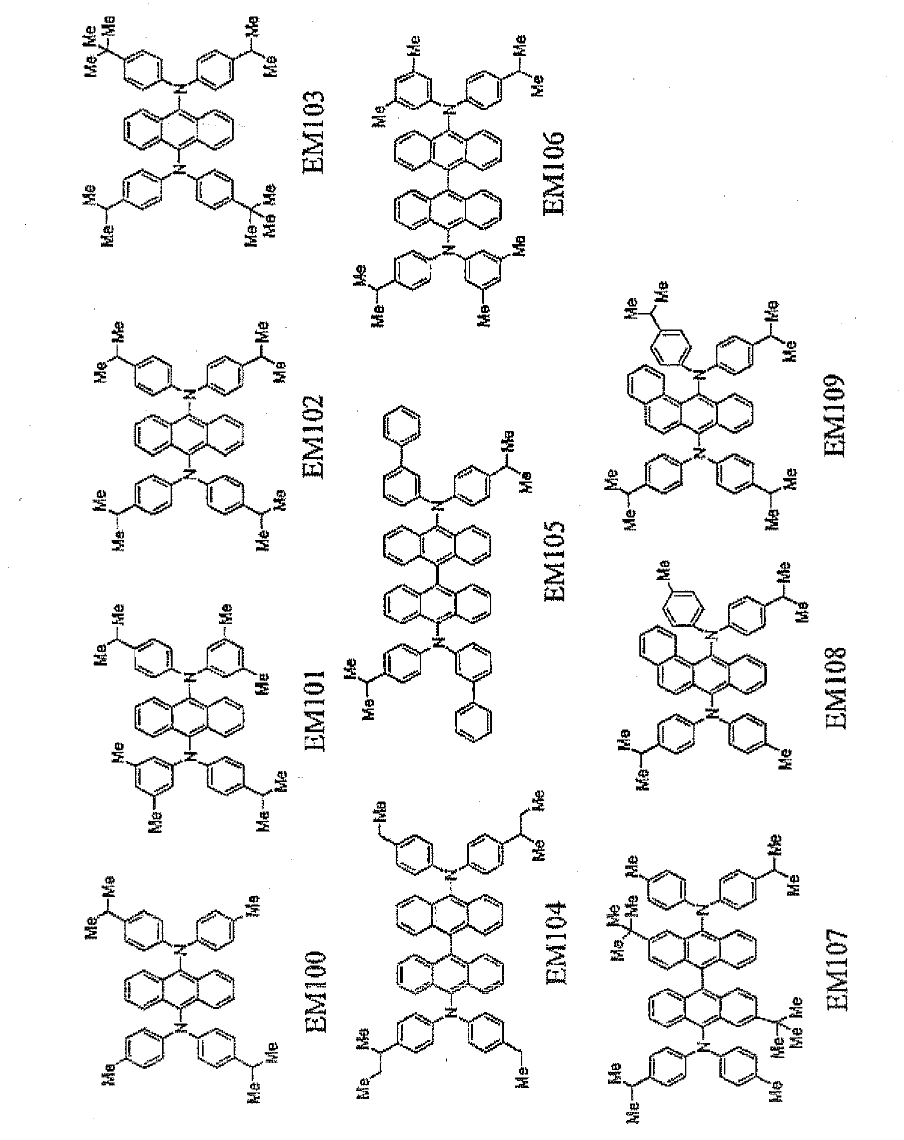

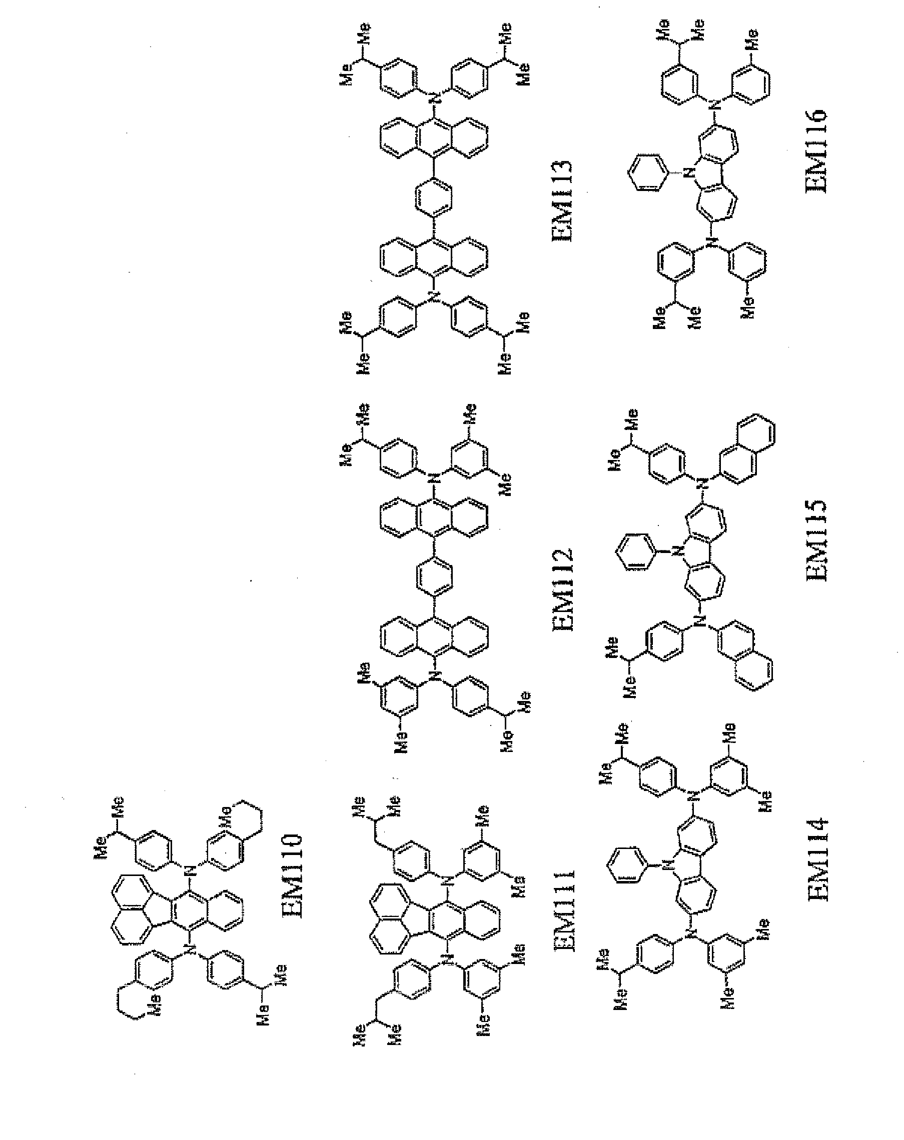

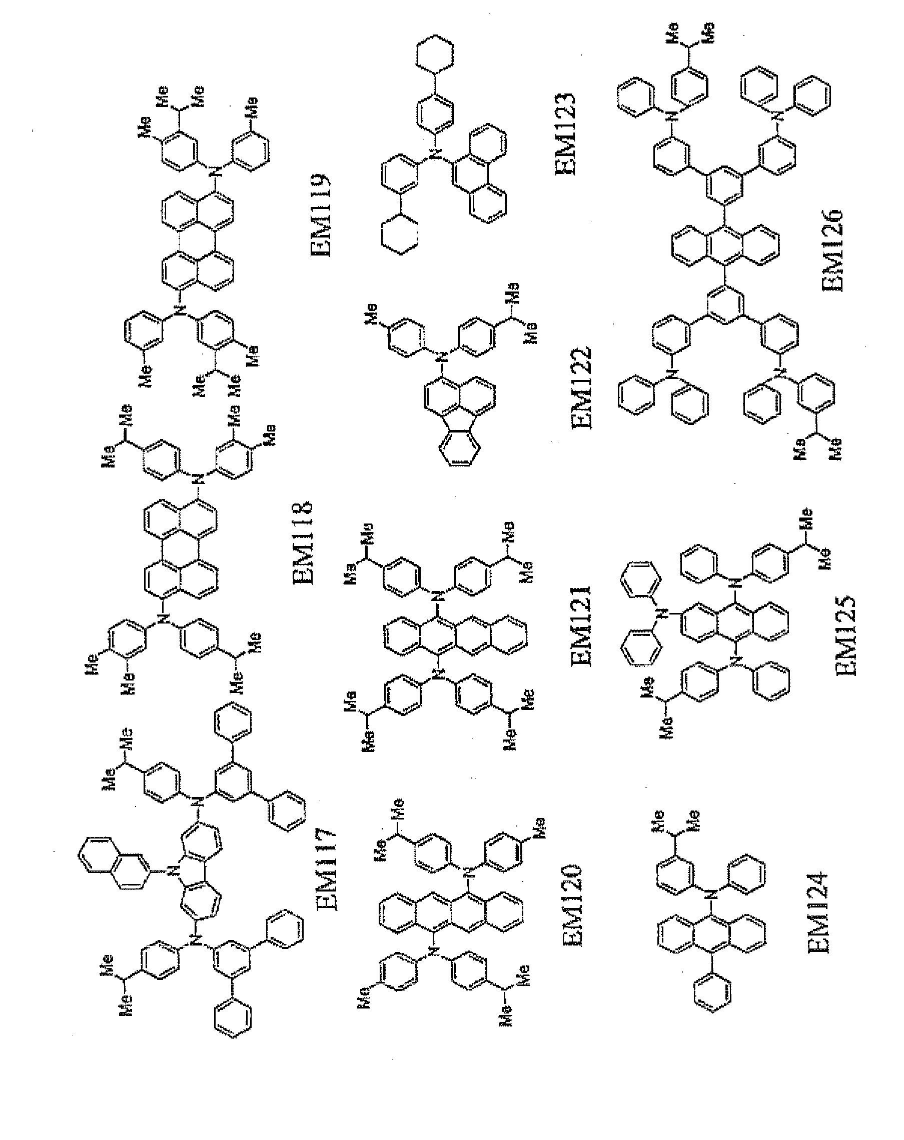

In Formulas (1), (2), (3) and (4), Ar₁ to Ar₁₆ are preferably a substituted or non-substituted phenyl group, and in Formulas (3) and (4), Z₁ to Z₃ are preferably a substituted or non-substituted phenylene group.
Also, in Formulas (1), (2), (3) and (4), m1, m2, m3, m4 and m5 each are preferably 2.
At least one repeating unit A selected from the divalent groups derived from the compounds represented by Formulas (1) to (4) described above is contained in a proportion of preferably 0.1 or more and 99.9 mole % or less, more preferably 0.1 or more and 10.0 mole % or less in a molecule of the high polymer compound.

Formula (5) shall be explained below:

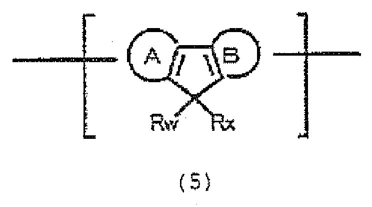

In Formula (5), an A ring and a B ring each represent independently a substituted or non-substituted aromatic hydrocarbon ring having 6 to 60 ring-forming carbon atoms or a substituted or non-substituted aromatic heterocyclic ring having 3 to 40 ring-forming atoms.
The specific examples of the aromatic hydrocarbon ring and the aromatic heterocyclic ring and the preferred groups thereof include rings obtained by converting the aryl groups and the aromatic heterocyclic groups represented by Ar₁ to Ar₄ in Formula (1) described above into zero-valent groups.
In Formula (5), Rw and Rx each represent independently a hydrogen atom, a substituted or non-substituted alkyl group having 1 to 50 ring-forming carbon atoms, a substituted or non-substituted aryl group having 6 to 60 ring-forming carbon atoms, a substituted or non-substituted amino group, a substituted or non-substituted silyl group, a substituted or non-substituted alkoxy group having 1 to 50 ring-forming carbon atoms, a substituted or non-substituted aryloxy group having 6 to 50 ring-forming carbon atoms, a substituted or non-substituted arylthio group having 6 to 50 ring-forming carbon atoms, a substituted or non-substituted alkoxycarbonyl group having 1 to 50 ring-forming carbon atoms, a halogen atom, a cyano group, a nitro group, a hydroxyl group or a carboxyl group, and the above respective groups may be combined with each other to form rings.
The specific examples of the above respective groups and the preferred groups thereof include the same groups as in R₁ of Formula (1) described above.

Formula (6) shall be explained below:

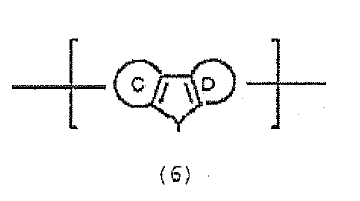

In Formula (6), a C ring and a D ring each represent independently a substituted or non-substituted aryl ring having 6 to 60 ring-forming carbon atoms or a substituted or non-substituted aromatic heterocyclic ring having 3 to 40 ring-forming atoms.
The specific examples of the aromatic hydrocarbon ring and the aromatic heterocyclic ring and the preferred groups thereof include rings obtained by converting the aryl groups and the aromatic heterocyclic groups represented by Ar₁ to Ar₄ in Formula (1) described above into zero-valent groups
In Formula (6), Y represents an oxygen atom, a substituted or non-substituted nitrogen atom, a substituted or non-substituted silicon atom, a substituted or non-substituted phosphorus atom, a sulfur atom, -O-C(Rk)₂- and -N(R1)-C(Rm)₂-.
Rk and Rm represent a hydrogen atom, a substituted or non-substituted alkyl group having 1 to 50 ring-forming carbon atoms, a substituted or non-substituted aryl group having 6 to 60 ring-forming carbon atoms, a substituted or non-substituted amino group, a substituted or non-substituted silyl group, a substituted or non-substituted alkoxy group having 1 to 50 ring-forming carbon atoms, a substituted or non-substituted aryloxy group having 6 to 50 ring-forming carbon atoms, a substituted or non-substituted arylthio group having 6 to 50 ring-forming carbon atoms, a substituted or non-substituted alkoxycarbonyl group having 1 to 50 ring-forming carbon atoms, a halogen atom, a cyano group, a nitro group, a hydroxyl group or a carboxyl group, and the above respective groups may be combined with each other to form rings. Two groups of Rk and Rm may be the same as or different from each other. R1 represents a hydrogen atom, a substituted or non-substituted alkyl group having 1 to 50 ring-forming carbon atoms or a substituted or non-substituted aryl group having 6 to 60 ring-forming carbon atoms.
The specific examples of the respective groups represented by Rk, Rl and Rm and the preferred groups thereof include the same groups as in R₁ of Formula (1) described above.

Further, the high polymer compound of the present invention preferably comprises at least one repeating unit C selected from the following Formulas (7), (8), (9) and (10):

-Ar₁₇- (7)

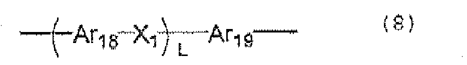

-Ar₂₀-X₂- (9)

-X₃- (10)

In Formulas (7) to (10), Ar₁₇, Ar₁₈, Ar₁₉ and Ar₂₀ each represent independently a substituted or non-substituted arylene group having 6 to 60 ring-forming carbon atoms, a substituted or non-substituted divalent aromatic heterocyclic group having 3 to 40 ring-forming atoms or a divalent group having a metal complex.
The specific examples of the above respective groups and the preferred groups thereof include groups obtained by converting the aryl groups and the aromatic heterocyclic groups represented by Ar₁ to Ar₄ in Formula (1) described above into divalent groups.
In Formulas (8) to (10), X₁, X₂ and X₃ each represent independently -CR₃=CR₄-, -C≡C- or N(R₅)-. R₃ and R₄ each represent independently a hydrogen atom, an alkyl group, a substituted or non-substituted aryl group having 6 to 60 ring-forming carbon atoms, a substituted or non-substituted aromatic heterocyclic group having 3 to 40 ring-forming atoms, a substituted or non-substituted carboxyl group or a cyano group. R₅ represents a hydrogen atom, an alkyl group, a substituted or non-substituted aryl group having 6 to 60 ring-forming carbon atoms, a substituted or non-substituted aromatic heterocyclic group having 3 to 40 ring-forming atoms, a substituted or non-substituted aralkyl group having 7 to 60 ring-forming carbon atoms or a group containing a substituted amino group- When R₃, R₄ and R₅ each are plurally present, they may be the same or different.

The specific examples of the respective groups represented by R_{3,} R₄ and R₅ and the preferred groups thereof include the same groups as in R₁ of Formula (1) described above.
In Formula (8), L represents 1 or 2.
Substituents for the substituted or non-substituted groups in Ar₁₇ to Ar₂₀ include the same groups as in R₁ described above.

The carbon atoms and the atomic numbers of the respective groups in the respective formulas described above are numbers which do not include those of the substituents.
In ┌the substituted or non-substituted --- groups┘ in the respective formulas described above, optional substituents include an alkyl group having 1 to 20 carbon atoms, a cycloalkyl group having 3 to 10 carbon atoms, an aryl group having 6 to 30 ring-forming carbon atoms, an alkoxy group having 1 to 20 carbon atoms, a cycloalkoxy group having 3 to 10 carbon atoms, an aryloxy group having 6 to 30 ring-forming carbon atoms, an aralkyl group having 7 to 31 carbon atoms (an aryl part has 6 to 30 ring-forming carbon atoms), a heterocyclic group having 3 to 30 ring-forming carbon atoms, a mono- or dialkylamino group having an alkyl group having 1 to 20 carbon atoms, a mono- or diarylamino group having an aryl group having 6 to 30 ring-forming carbon atoms, a halogen atom, a nitro group, a cyano group, a hydroxyl group and the like.

The high polymer compound of the present invention may be any of a random copolymer (-ABBABBBAAABA-), an alternating copolymer (-ABABABABABAB-), a block copolymer (-AAAAAABBBBBB-) and a graft copolymer (either of the repeating unit A and the repeating unit B may be a principal chain, and either of them may be a side chain) each comprising the repeating unit A and the repeating unit B. Further, the repeating unit C may be inserted into an optional position.

A number average molecular weight (Mn) of the high polymer compound of the present invention is preferably 10³ to 10⁸, more preferably 10⁴ to 10⁶. Also, a weight average molecular weight (Mw) thereof is preferably 10³ to 10⁸, more preferably 10⁵ to 10⁶. Both molecular weights were determined by analyzing them with standard polystyrene using a size exclusion chromatography (SEC).

In the high polymer compound of the present invention, a mole ratio or the repeating unit A to the repeating unit B is preferably 0.1 : 99.9 to 99.9 : 0.1, more preferably 1 : 99 to 30 : 70 and particularly preferably 3 : 97 to 20 : 80.

The high polymer compound of the present invention can be produced by subjecting a compound represented by, for example, the following Formula (A):

Y¹-(repeating unit A)-Y² (A)

and a compound represented by the following Formula (B);

Y¹-(repeating unit B) -Y² (B)

to condensation polymerization.

In Formula (A) and Formula (B), Y¹ and Y² each represent independently a halogen atom (a chlorine atom, a bromine atom and an iodine atom), a sulfonate group (-OSO₂R¹; R¹ is a group selected from the substituted or non-substituted aryl groups and the substituted or non-substituted alkyl groups which have been shown as the examples in Ar₁ to Ar₄), a methoxy group, a boric ester group, a boric acid group (-B(OH)2), -MgX¹ (X¹ is a halogen atom such as a chlorine atom, a bromine atom and an iodine atom), -ZnX¹ (X¹ is the same as described above) or - SnR¹ (R¹ is the same as described above), preferably a halogen atom, a boric ester group or a boric acid group.

The following groups are shown as the examples of the boric ester group described above:

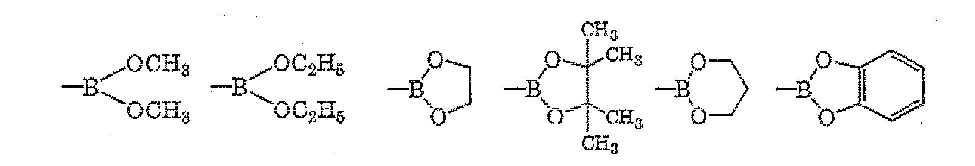

The condensation polymerization is carried out under the presence of, if necessary, a catalyst and a base. The above catalyst includes, for example, catalysts comprising transition metal complexes including palladium complexes such as palladium[tetrakis(triphenylphosphine)], [tris(dibenzylideneacetone)]dipalladium, palladium acetate and the like, nickel complexes such as nickel[tetrakis(triphenylphosphine)], [1,3-bis(diphenylphosphino)propane]dichloronickel, [bis(1,4-cyclooctadiene)]nickel and the like and, if necessary, ligands such as triphenylphosphine, tri(t-butylphosphine), tricyclohexylphosphine, diphenylphosphinopropane, bipyridyl and the like. The above catalysts can be used alone or in a mixture of two or more kinds thereof. A use amount of the above catalysts is preferably 0.001 to 300 mole %, more preferably 0.01 to 20 mole % based on the total mole number of the compounds represented by Formulas (A) and (B).

The base described above includes inorganic bases such as sodium carbonate, potassium carbonate, cesium carbonate, potassium fluoride, cesium fluoride, tripotassium phosphate and the like and organic bases such as tetrabutylammonium fluoride, tetrabutylammonium chloride, tetrabutylammonium bromide, tetrabutylammonium hydroxide and the like. A use amount of the above bases is preferably 0.5 to 20 equivalent, more preferably 1 to 10 equivalent based on the total mole number of the compounds represented by Formulas (A) and (B).

The condensation polymerization may be carried out under the presence of an organic solvent. The organic solvent includes toluene, xylene, mesitylene, tetrahydrofuran, 1,4-dioxane, dimethoxyethane, N,N-dimethylacetamide, N,N-dimethylformamide and the like. These organic solvents may be used alone or in combination of two or more kinds thereof. A use amount of the organic solvent is such an amount that a concentration of the monomers (the compounds of Formulas (A) and (B)) is preferably 0.1 to 90 % by weight, more preferably 1 to 50 % by weight.

The condensation polymerization temperature shall not specifically be restricted as long as it falls in a range in which the reaction medium is maintained in a liquid form. It is preferably -100 to 200°C, more preferably 0 to 120°C. The polymerization time is varied according to the polymerization conditions such as the polymerization temperature and the like, and it is preferably 1 hour or longer, more preferably 2 to 500 hours.

With respect to the condensation polymerization produce, the targeted high polymer compound can be obtained by adding the reaction solution to lower alcohol such as methanol to deposit a precipitate and filtering and drying it according to publicly known methods. When the high polymer compound has a low purity, it can be refined by an ordinary method such as recrystallization, Soxhlet continuous extraction, column chromatography and the like.

The material of the present invention for organic EL contains the high polymer compound of the present invention.
In addition to the high polymer compound, it preferably further contains at least one compound selected from the group consisting of a homopolymer comprising at least one repeating unit A selected from the divalent groups derived from the compounds represented by Formulas (1) to (4) or a copolymer containing the above repeating unit A, a homopolymer comprising at least one repeating unit B selected from Formulas (5) and (6) and a copolymer containing the above repeating unit B.

In the organic EL device of the present invention, an organic compound layer comprising at least one layer is interposed between a pair of electrodes. At least one of the organic compound layers is a light emitting layer. A thickness of the light emitting layer is preferably 5 to 200 nm, and it is more preferably 10 to 40 nm since a voltage applied to the device can be reduced. The high polymer compound of the present invention is contained in at least one of the organic compound layers, preferably the light emitting layer, Various intermediate layers are preferably allowed to be present between the above electrode and the organic compound layer. The above intermediate layers include, for example, a hole injecting layer, a hole transporting layer, an electron injecting layer, an electron transporting layer and the like. Various organic and inorganic compounds are known as materials for forming the above layers. The representative device constitution of the above organic EL device includes:
(1) Anode/light emitting layer/cathode
(2) Anode/hole injecting layer/light emitting layer/cathode
(3) Anode/light emitting layer/electron injecting layer/cathode
(4) Anode/hole injecting layer/light emitting layer/electron injecting layer/cathode
(5) Anode/organic semiconductor layer/light emitting layer/cathode
(6) Anode/organic semiconductor layer/electron barrier layer/light emitting layer/cathode
(7) Anode/organic semiconductor layer/light emitting layer/adhesion improving layer/cathode
(8) Anode/hole injecting layer/hole transporting layer/light emitting layer/electron injecting layer/cathode
(9) anode/insulating layer/light emitting layer/insulating layer/cathode,
(10) anode/inorganic semiconductor layer/insulating layer/light emitting layer/insulating layer/cathode
(11) anode/organic semiconductor layer/insulating layer/light emitting layer/insulating layer/cathode,
(12) anode/insulating layer/hole injecting layer/hole transporting layer/light emitting layer/insulating layer/cathode and
(13) anode/insulating layer/hole injecting layer/hole transporting layer/light emitting layer/electron injecting layer/cathode
Among them, usually the constitution of (8) is preferably used, but the device constitution shall not be restricted to them.

Usually, an organic EL device is prepared on a light transmitting substrate. This light transmitting substrate is a substrate for supporting an organic EL device. It is preferably a substrate in which light in a visible region of 400 to 700 nm has a transmittance of 50 % or more, and a flat substrate is preferably used. For example, a glass plate, a synthetic resin plate and the like are suitably used as the above light transmitting substrate. In particular, the glass plate includes plates prepared by molding soda lime glass, barium strontium-containing glass, lead glass, aluminosilicate glass, borosilicate glass, barium borosilicate glass, quartz and the like. The synthetic resin plate includes plates of polycarbonate resins, acryl resins, polyethylene terephthalate resins, polyether sulfide resins, polysulfone resins and the like.

Anodes prepared from electrode materials such as metals, alloys, electrically conductive compounds or mixtures thereof each having a large work function (4 eV or more) are preferably used as the anode. The specific examples of the above electrode materials include metals such as Au and the like and electrically conductive materials such as CuI, ITO (indium tin oxide), SnO₂, ZnO, In-Zn-O and the like. The anode is prepared by forming a thin film from the above electrode materials by a method such as a vapor deposition method, a sputtering method and the like. When light emitted from the light emitting layer is taken out from the anode, a transmittance of light in the anode based on light emitted is preferably larger than 10 %. A sheet resistance of the anode is preferably several hundred Ω/square or less. A film thickness of the anode is, though depending on the material, usually 10 nm to 1 µm, preferably 50 to 200 nm.

Cathodes prepared by using metals, alloys, electrically conductive compounds and mixtures thereof each having a small work function (4 eV or less) for electrode materials are used as the cathode. The specific examples of the above electrode materials include sodium, sodium-potassium alloys, magnesium, lithium, magnesium silver alloys, aluminum/aluminum oxide, Al/Li₂O, Al/LiO₂, Al/LiF, aluminum lithium alloys, indium, rare earth metals and the like. The cathode is prepared by forming a thin film from the above electrode materials by a method such as vapor deposition, sputtering and the like. When light emitted from the organic compound layer is taken out from the cathode, a transmittance of the cathode based on light emitted is preferably larger than 10 %. A sheet resistance of the cathode is preferably several hundred Ω/square or less, and a film thickness thereof is usually 10 nm to 1 µm, preferably 50 to 200 nm

In the organic EL device of the present invention, at least one layer selected from a chalcogenide layer, a metal halide layer and a metal oxide layer (hereinafter, they shall be referred to as a surface layer) is preferably disposed at least on one surface of a pair of the electrodes prepared in the manner described above. To be specific, a layer containing chalcogenides (including oxides) of metals such as silicon, aluminum and the like is disposed preferably on an anode surface at an organic compound layer side, and a metal halide layer or a metal oxide layer is disposed preferably on a cathode surface at the organic compound layer side. This makes it possible to stably drive the organic EL device. The chalcogenide described above preferably includes, for example, SiOx (1≤x≤2), Alox (1≤x≤1.5), SiON, SiAlON and the like; the metal halide preferably includes, for example, LiF, MgF₂, CaF₂, rare earth metal halides and the like; and the metal oxide preferably includes, for example, Cs₂O, Li₂O, MgO, SrO, BaO, CaO and the like.

Further, in the organic EL device of the present invention, a mixed region of an electron transmitting compound and a reducing dopant or a mixed region of a hole transmitting compound and an oxidizing dopant is preferably disposed as well at least on one surface of a pair of the electrodes prepared in the manner described above. This allows the electron transmitting compound to be reduced and turned into an anion and makes it easier to inject and transmit electrons to a light emitting medium in the mixed region. Further, the hole transmitting compound is oxidized and turned into a cation, and holes are more readily injected and transmitted to the light emitting medium in the mixed region. The preferred oxidizing dopant includes various Lewis acids and acceptor compounds. The preferred reducing dopant includes alkali metals, alkali metal compounds, rare earth metals and compounds thereof.

In the organic EL device of the present invention, the light emitting layer has:
(i) injecting function: a function in which a hole can be injected from an anode or a hole injecting layer in applying an electric field and in which an electron can be injected from a cathode or an electron injecting layer,
(ii) transporting function: a function in which a charge (electron and hole) injected is transferred by virtue of a force of an electric field and
(iii) light emitting function: a function in which a field for recombination of an electron and a hole is provided and in which this is connected to light emission.

A method for forming a layer (an organic compound layer, particularly a light emitting layer) containing the high polymer compound of the present invention includes a method in which a film is formed by using the solution of the present invention containing the high polymer compound.
The above solution for forming a film is required to contain at least one kind of the high polymer compound of the present invention, and it may contain, in addition to the above high polymer compound, additives such as a hole transporting material, an electron transporting material, a light emitting material, a solvent, a stabilizer and the like.
A viscosity of the solution for forming a film falls preferably in a range of, though different depending on a printing method, 1 to 20 mPa·s at 25°C in order to prevent clogging and delivering failure in discharging when the ink composition is delivered through a discharge device.

The solution for forming a film may contain additives for controlling a viscosity and/or a surface tension, for example, a thickener (a high molecular weight compound, a poor solvent for the high polymer compound of the present invention and the like), a viscosity reducing agent (a low molecular weight compound and the like), a surfactant and the like. Further, antioxidants such as phenol base antioxidants, phosphorus base antioxidants and the like which do not exert an influence on the performance.

Shown as examples of a solvent for the solution for forming a film are chlorine base solvents such as chloroform, methylene chloride, 1,2-dichloroethane, 1,1,2-trichloroethane, chlorobenzene, o-dichlorobenzene and the like; ether base solvents such as tetrahydrofuran, dioxane, anisole and the like; aromatic hydrocarbon base solvents such as toluene, xylene and the like; aliphatic hydrocarbon base solvents such as cyclohexane, methylcyclohexane, n-pentane, n-hexane, n-heptane, n-octane, n-nonane, n-decane and the like; ketone base solvents such as acetone, methyl ethyl ketone, cyclohexanone, benzophenone, acetophenone and the like; ester base solvents such as ethyl acetate, butyl acetate, ethyl cellosolve acetate, methyl benzoate, phenyl acetate and the like; polyhydric alcohols and derivatives thereof such as ethylene glycol, ethylene glycol monobutyl ether, ethylene glycol monoethyl ether, ethylene glycol monomethyl ether, dimethoxyethane, propylene glycol, diethoxyethane, triethylene glycol monoethyl ether, glycerin, 1/2-hexanediol and the like; alcohol base solvents such as methanol, ethanol, propanol, isopropanol, cyclohexanol and the like; sulfoxide base solvents such as dimethylsulfoxide and the like; and amide base solvents such as N-methyl-2-pyrrolidone, N,N-dimethylformamide and the like. The above organic solvents can be used alone or in combination, of a plurality thereof. Among them, the aromatic hydrocarbon base solvents, the ether base solvents, the aliphatic hydrocarbon base solvents, the ester base solvents and the ketone base solvents are preferred from the viewpoints of a solubility, a uniformity of the film, a viscosity characteristic and the like, and more preferred are toluene, xylene, ethylbenzene, diethylbenzene, triethylbenzene, n-propylbenzene, isopropylbenzene, n-butylbenzene, isobutylbenzene, 5-butylbenzene, n-hexylbenzene, cyclohexylbenzene, 1-methylnaphthalene, tetralin, anisole, ethoxybenzene, cyclohexane, bicyclohexyl, cyclohexenylcyclohexanone, n-heptylcyclohexane, n-hexylcyclohexane, decalin, methyl benzoate, cyclohexanone, 2-propylcyclohexanone, 2-heptanone, 3-heptanone, 4-heptanone, 2-octanone, 2-nonanone, 2-decanone, cyclohexyl ketone, acetophenone and benzophenone.

Two or more kinds of the solvents are preferably contained in the solution from the viewpoints of a film-forming property, the device characteristics and the like, and they are more preferably two to three kinds, further preferably two kinds.
When two kinds of the solvents are contained in the solution, one kind of the solvent among them may stay in a solid state at 25°C. One kind of the solvent has a boiling point of preferably 180°C or higher, more preferably 200°C or higher from the viewpoint of a film-forming property. Both of two kinds of the solvents dissolve preferably 1 wt % or more of the aromatic polymer at 60°C from the viewpoint of a viscosity, and one kind of the solvent among two kinds of the solvents dissolves preferably 1 wt % or more of the aromatic polymer at 25°C.
When two kinds of the solvent are contained in the solution, the solvent having the highest boiling point accounts for preferably 40 to 90 % by weight, more preferable 50 to 90 % by weight and further preferably 65 to 85 % by weight based on a weight of the whole solvents contained in the solution from the viewpoint of a viscosity and a film-forming property.
The aromatic polymer of the present invention contained in the solution may be of either a single kind or two more kinds, and polymer compounds other than the aromatic polymer of the present invention may be contained therein as long as the device characteristics and the like are not damaged.
Water, metals and salts thereof may be contained in the solution of the present invention in a range of 1 to 1000 ppm. The metals include, to be specific, lithium, sodium, calcium, potassium, iron, copper, nickel, aluminum, zinc, chromium, manganese, cobalt, platinum, iridium and the like. Further, silicon, phosphorus, fluorine, chlorine and/or bromine may be contained in a range of 1 to 1000 ppm.

A thin film can be prepared by a spin coating method, a casting method, a micro gravure coating method, a gravure coating method, a bar coating method, a roll coating method, a wire bar coating method, a dip coating method, a spray coating method, a screen printing method, a flexographic printing method, an offset printing method, an ink jet printing method and the like using the solution of the present invention. Among them, a screen printing method, a flexographic printing method, an offset printing method and an ink jet printing method are preferably used for forming a film using the solution of the present invention, and the ink jet printing method is preferably used for forming the film. The thin film of the present invention is formed by the ink jet printing method.

When the thin film is prepared by using the solution of the present invention, the film can be baked at a temperature of 100°C or higher since a glass transition temperature of the polymer compound contained in the solution is high, and the device characteristics are reduced very slightly even by baking at a temperature of 130°C. The film can be baked at a temperature of 160°C or higher depending on the kind of the polymer compound.
A light emitting thin film, an electrically conductive thin film and an organic semiconductor thin film are shown as the examples of the thin film which can be prepared by using the solution of the present invention.

In the organic EL device of the present invention, an organic compound other than the high polymer compound described above may be contained, if desired, in the light emitting layer as long as the object of the present invention is not damaged, and a different light emitting layer containing a publicly known organic compound may be laminated on the light emitting layer containing the high polymer compound of the present invention.

For example, the light emitting layer may contain, in addition to the high polymer compound of the present invention, at least one compound selected from the group consisting of a homopolymer comprising at least one repeating unit A selected from the divalent groups derived from the compounds represented by Formulas (1) to (4) or a copolymer containing the above repeating unit A, a homopolymer comprising at least one repeating unit B selected from Formulas (5) and (6) and a copolymer containing the above repeating unit B in the high polymer compound of the present invention.

Further, the light emitting layer may contain 0.1 to 20 parts by weight of a publicly known fluorescent or phosphorescent dopant based on 100 parts by weight of the above high polymer compound. This allows the emission luminance and the luminous efficiency to be more improved. The fluorescent dopant described above is selected from amine base' compounds, chelate complexes such as tris(8-quinolinolate)aluminum complexes and the like, coumarin derivatives, tetraphenylbutadiene derivatives, bisstyrylarylene derivatives, oxadiazole derivatives and the like according to the luminescent color required. The phosphorescent dopant described above is preferably a metal complex compound containing at least one metal selected from Ir, Ru, Pd, Pt, Os and Re, and the ligand has preferably at least one skeleton selected from a phenylpyridine skeleton, a bipyridyl skeleton and a phenanthroline skeleton. The specific examples of the above metal complex compound include tris(2-phenylpyridine)iridium, tris(2-phenylpyridine)ruthenium, tris(2-phenylpyridine)palladium, tris(2-phenylpyridine)platinum, tris(2-phenylpyridine)osmium, tris(2-phenylpyridine) rhenium, octaethylplatinum porphyrin, octaphenylplatinum porphyrin, octaethylpalladium porphyrin, octaphenylpalladium porphyrin and the like, but they shall not be restricted thereto, and the suitable complexes are selected in relation to the luminescent color required, the device performances and the high polymer compound.

Further, the light emitting layer may contain 0.1 to 50 parts by weight of an arylamine compound and/or a styrylamine compound based on 100 parts by weight of the above high polymer compound. This allows the emission luminance and the luminous efficiency to be more improved. The above arylamine compound includes, for example, compounds disclosed in WO02/20459, Japanese Patent Application Laid-Open No. 140235/2006, Japanese Patent Application Laid-Open No. 306745/2006, WO2004/09211, WO2004/044088, Japanese Patent Application Laid-Open No. 256979/2006, Japanese Patent Application Laid-Open No. 230960/2007, WO2004/083162 Japanese Patent Application Laid-Open No. 298793/2006, WO20/20460, Japanese Patent Application Laid-Open No. 137824/2007, Japanese Patent Application Laid-Open No. 45725/2007, Japanese Patent Application Laid-Open No. 068087/2005 and the like, and the above styrylamine compound includes, for example, compounds disclosed in WO02/20459.
Further, the light emitting layer may contain 0.1 to 50 parts by weight of a metal complex compound based on 100 parts by weight of the above high polymer compound. This allows the emission luminance and the luminous efficiency to be more improved.

The hole injecting and transporting layer is a layer for assisting injection of a hole into the light emitting layer to transport it to the light emitting region, and it has a large hole mobility and shows usually as small ionization energy as 55 eV or less. A material which transports a hole to the light emitting layer by a lower electric field strength is preferred for the above hole injecting and transporting layer, and more preferred is a material in which a mobility of a hole is at least 10⁻⁶ cm²/V•second in applying an electric field of, for example, 10⁴ to 10⁶ V/cm. Optional materials selected from materials which have so far conventionally been used as charge transporting materials for holes in photoconductive materials and publicly known materials used for hole injecting layers in organic EL devices can be used as the above material. The above hole injecting and transporting layer can be prepared by forming a thin film from the hole injecting and transporting material by, for example, a publicly known method such as a vacuum deposition method, a spin coating method, a casting method, an LB method and the like. In this case, a film thickness of the hole injecting and transporting layer shall not specifically be restricted, and it is usually 5 nm to 5 µm.

The electron injecting and transporting layer is a layer for assisting injection of an electron into the light emitting layer to transport it to the light emitting region, and it has a large electron mobility. Also, the adhesion improving layer is a layer comprising particularly a material having a good adhesive property with the cathode in the above electron injecting layer. A material used for the electron injecting layer is suitably a metal complex of 8-hydroxyquinoline or a derivative thereof. With respect to the specific examples of the metal complex of 8-hydroxyquinoline or a derivative thereof, metal chelate oxynoid compounds containing a chelate of oxine (in general, 8-quinolinol or 8-hydroxyquiniline), for example, tris(8-quinolinol)aluminum can be used as the electron injecting material. In the organic EL device of the present invention, picture element defects are liable to be causes by leak and short since an electric field is applied to an ultrathin film. In order to prevent the above matter, an insulating thin film layer may be interposed between a pair of the electrodes.

A material used for the insulating layer includes, for example, aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium, oxide, vanadium oxide and the like, and mixtures and laminates thereof may be used as well.

As described above, the organic EL device of the present invention is produced by forming the anode, the light emitting layer, if necessary, the hole injecting layer and, if necessary, the electron injecting layer and forming finally the cathode according to the materials and the forming methods each described above. Also, the organic EL device may be produced as well in an order of from the cathode to the anode which is reverse to the order described above.

### EXAMPLES

Next, the present invention shall be explained in further details with reference to examples, but the present invention shall by no means be restricted by these examples.

### Example 1

### (1) Synthesis of monomer:

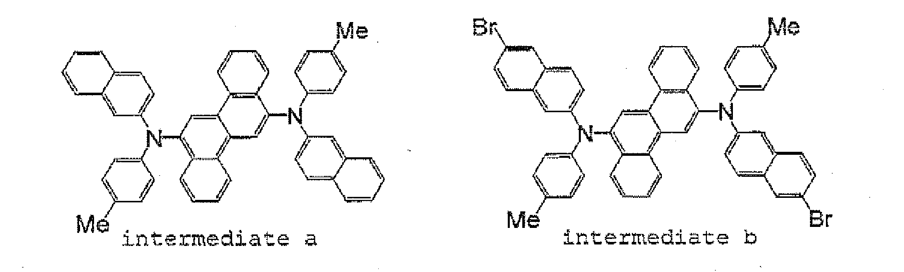

A three neck flask of 300 ml equipped with a cooling tube was charged with 3.8 g (10 mmol) of 6,12-dibromochrysene, 5.83 g (25 mmol) of trinaphthylamine, 0.03 g (1.5 mmol %) of palladium acetate, 0.06 g (3 mol %) of tri-t-butylphosphine, 2.4 g (25 mmol) of t-butoxysodium and 100 ml of dry toluene under argon atmosphere, and then the mixture was dried at 100°C for a night. After finishing the reaction, crystal deposited was obtained by filtering and washed with 50 ml of toluene and 100 ml of methanol to obtain 5.9 g of a pale yellow powder (intermediate a, yield: 85 %).
Then, the three neck flask was charged with 5.9 g (8.54 mmol) of the intermediate a and 150 ml of N,N'-dimethylformamide under argon atmosphere, and then a solution prepared by dissolving 3-11 g (17.5 mmol) of N-bromosuccinimide in 10 ml of dry N,N'-dimethylformamide was dropwise added thereto at 25 to 35°C. After dropwise adding, the reaction liquid was refluxed by heating to carry out the reaction for 2 hours. Then, the reaction liquid was left cooling down to room temperature, and when the temperature reached 25°C or lower, 150 ml of methanol was dropwise added thereto. Crystal deposited was obtained by filtering and washed with methanol. Then, the crystal was dried under reduced pressure to thereby obtain 5.4 g (6.36 mmol, yield: 78 %, HPLC: 99.5 %) of a targeted compound, an intermediate b (monomer 1).

### (2) Synthesis of polymer compound:

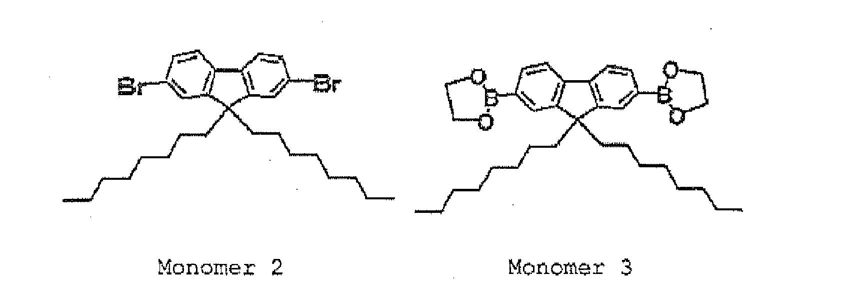

A three neck flask of 300 ml equipped with a cooling tube was charged with 0.203 g (0.24 mmol) of the intermediate b, 2.06 g (3.76 mmol) of a monomer 2, 2.10 g (3.96 mmol) of a monomer 3, 2.7 mg of palladium acetate, 29.6 mg of tris(2-methoxyphenyl)phosphine, Aliquat 336 (0.52 g, manufactured by Aldrich Corporation) and 40 ml of dry toluene under argon atmosphere, and the mixture was heated at 105°C. A 2M Na₂CO₃ aqueous solution (10.9 ml) was dropwise added to the above reaction solution, and the solution was refluxed for 8 hours. After finishing the reaction, 50 mg of phenyl borate was added thereto to further carry out the reaction for 2 hours under refluxing. Then, a sodium diethyldithiacarbamate aqueous solution was added thereto and stirred at 80°C for 2 hours. After cooling down, the compound was deposited by extraction and concentration of the organic solvent and obtained by filtering, and it was washed in an order of ion-exchanged water, a 3 % acetic acid aqueous solution, ion-exchanged water and methanol. The deposit thus obtained was dissolved in toluene by heating, and the solution was allowed to pass through a silica gel column, whereby it was refined. The toluene solution obtained was concentrated and dropwise added to a methanol solution to carry out reprecipitation treatment, and the deposit was obtained by filtering and dried to obtain a high polymer compound 1 (1.98 g).
A molecular weight of the high polymer compound 1 thus obtained was Mn = 28,000 and Mw = 52,000 (measured according to standard polystyrene).
A 1.2 wt % xylene solution of the high polymer compound 1 was prepared. A PEDOT/PSS aqueous solution (Bayton P, manufactured by Bayer AG.) was used to form a film having a thickness of 50 nm as a hole transporting layer by a spin coating method on a glass substrate provided with an ITO film in a thickness of 150 nm by a sputtering method, and the film was dried at 200°C for 10 minutes on a hot plate. Next, the xylene solution prepared above was used to form a light emitting layer at 900 rpm by spin coating. The film thickness was about 100 nm. This was dried at 130°C for 1 hour under argon atmosphere and then further dried under vacuum. Then, Alq was deposited as an electron transporting layer in a thickness of 20 nm, and lithium fluoride was deposited as a cathode in a thickness of 1 nm, followed by depositing aluminum thereon in a thickness of about 150 nm, whereby an organic EL device was prepared.
The device thus obtained was used to measure a peak wavelength, a maximum luminous efficiency and a half life at an initial emission luminance of 1000 nit, and the luminescent color was observed. The results thereof are shown in Table 7.

### Example 2

### (1) Synthesis of monomer:

A monomer 1 was prepared in the same manner as in Example 1.

### (2) Synthesis of high polymer compound:

A three neck flask of 300 ml equipped with a cooling tube was charged with 0.203 g (0.24 mmol) of the intermediate b, 1.80 g (3.28 mmol) of the monomer 2, 2.10 g (3.96 mmol) of the monomer 3, 0.104 g (0.44 mmol) of a monomer 4 each shown in Table 1, 2.7 mg of palladium acetate, 29.6 mg of tris(2-methoxyphenyl)phosphine, Aliquat 336 (0.52 g, manufactured by Aldrich Corporation) and 40 ml of dry toluene under argon atmosphere, and the mixture was heated at 105°C. A 2M Na₂CO₃ aqueous solution (10.9 ml) was dropwise added to the above reaction solution, and the solution was refluxed for 8 hours. After finishing the reaction, 50 mg of phenyl borate was added thereto to further carry out the reaction for 2 hours under refluxing. Then, a sodium diethyldithiacarbamate aqueous solution was added thereto and stirred at 80°C for 2 hours. After cooling down, the compound was deposited by extraction and concentration of the organic solvent and obtained by filtering, and it was washed in an order of ion-exchanged water, a 3 % acetic acid aqueous solution, ion-exchanged water and methanol. The deposit thus obtained was dissolved in toluene by heating, and the solution was allowed to pass through a silica gel column, whereby it was refined. The toluene solution obtained was concentrated and dropwise added to a methanol solution to carry out reprecipitation treatment, and the deposit was obtained by filtering and dried to obtain a high polymer compound 2 (1.88 g).
A device was prepared in the same manner as in Example 1. Analysis of the high polymer compound and evaluation of the device were carried out in the same manners as in Example 1, and the results thereof are shown together in Table 7.

### Examples 3 to 20 and Comparative Examples 1 to 2

The monomers 1 to 4 shown in Tables 1 to 6 were used to synthesize high polymer compounds 3 to 20 and comparative compounds 1 and 2 in the same manner as in Example 1 or 2. Analysis of the high polymer compounds synthesized and evaluation of the devices were carried out in the same manner as in Example 1, and the results thereof are shown together in Tables 7 to 8.

**Table 1**

| | Monomer 1 | Monomer 2 | Monomer 3 | Monomer 4 |
|---|---|---|---|---|
| Example 1 | 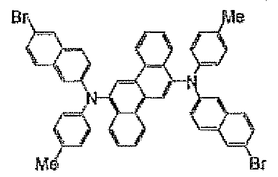 | 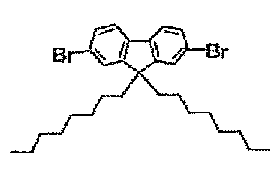 | 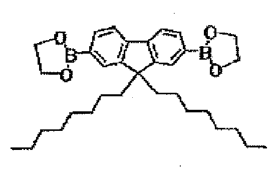 | None |
| Example 2 | 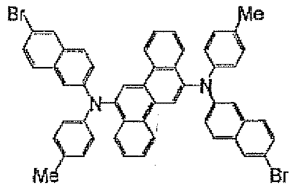 | 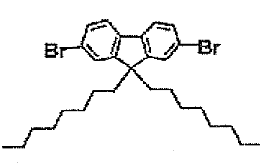 | 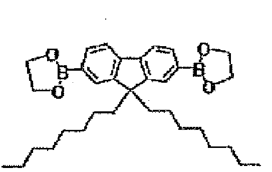 | 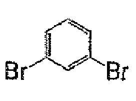 |
| Example 3 | 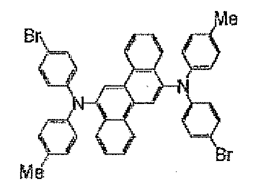 | 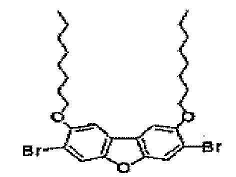 | 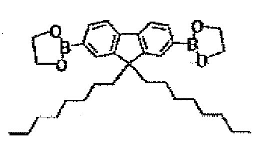 | None |
| Example 4 | 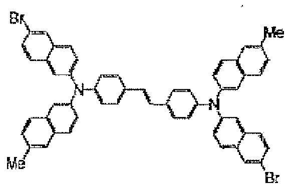 | 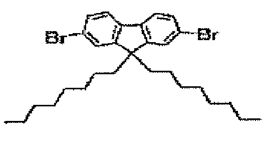 | 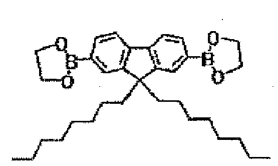 | None |

| | | | | |
|---|---|---|---|---|
| *: Me is methyl | | | | |

**Table 2**

| | Monomer 1 | Monomer 2 | Monomer 3 | Monomer 4 |
|---|---|---|---|---|
| Example 5 | 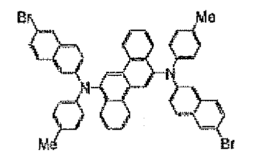 | 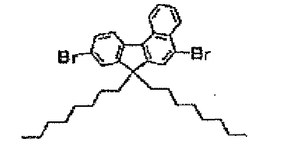 | 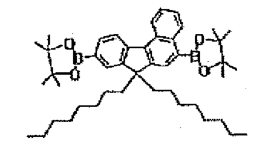 | None |
| Example 6 | 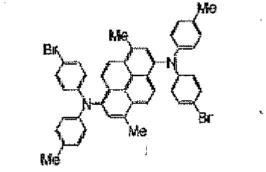 | 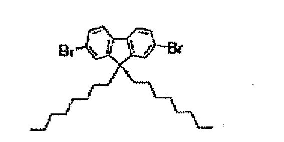 | 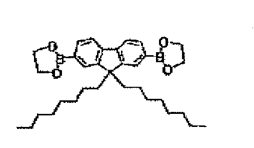 | None |
| Example 7 | 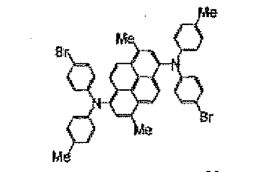 | 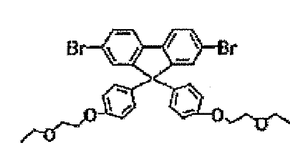 | 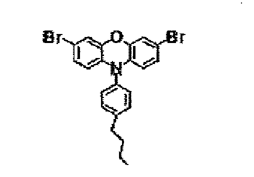 | 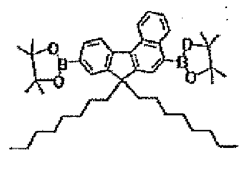 |
| Example 8 | 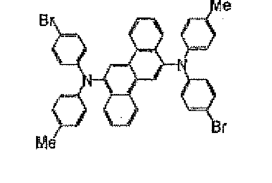 | 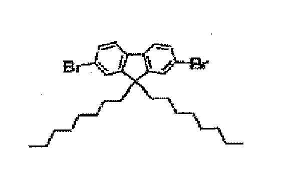 | 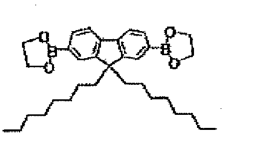 | 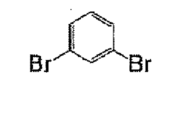 |

**Table 3**

| | Monomer 1 | Monomer 2 | Monomer 3 | Monomer 4 |
|---|---|---|---|---|
| Example 9 | 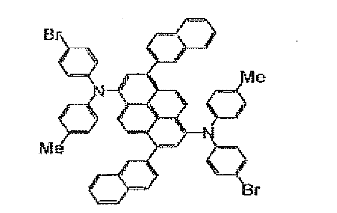 | 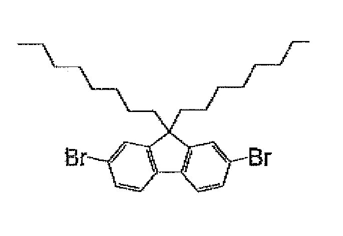 | 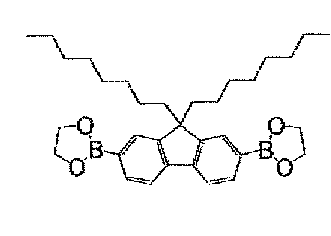 | None |
| Example 10 | 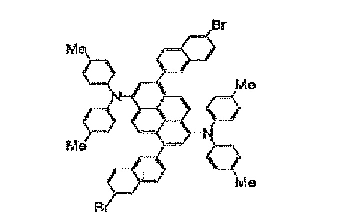 | 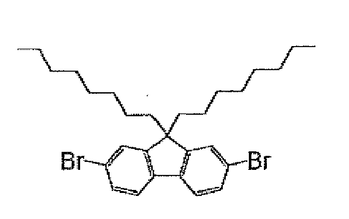 | 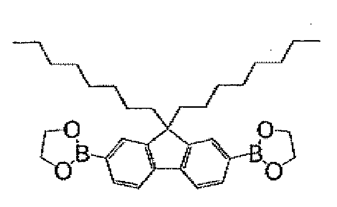 | 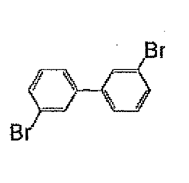 |
| Example 11 | 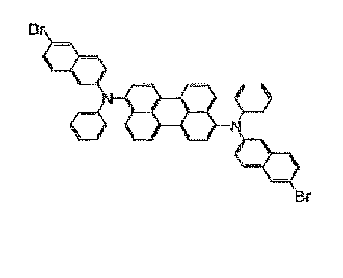 | 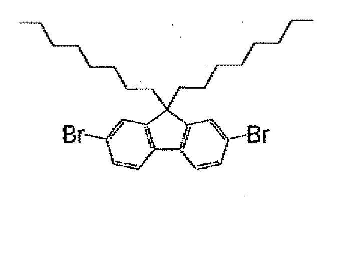 | 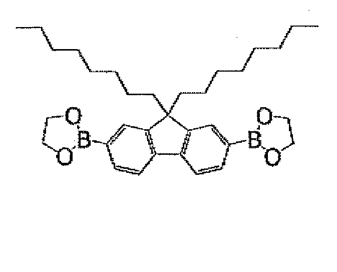 | None |

**Table 4**

| | Monomer 1 | Monomer 2 | Monomer 3 | Monomer 4 |
|---|---|---|---|---|
| Example 12 | 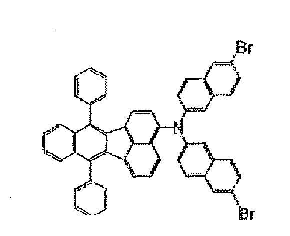 | 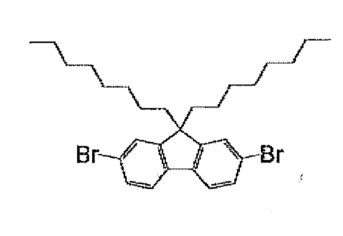 | 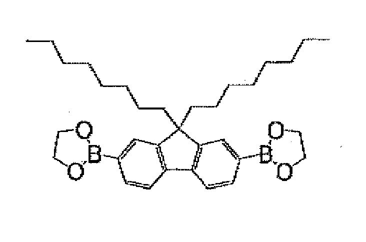 | None |
| Example 13 | 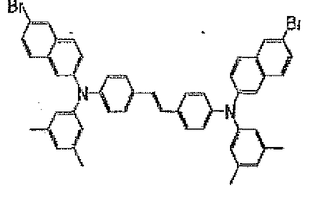 | 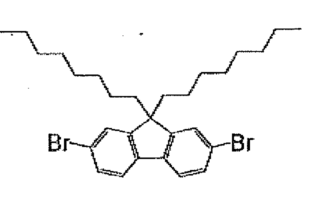 | 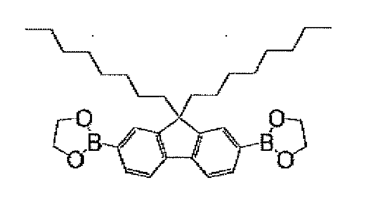 | None |
| Example 14 | 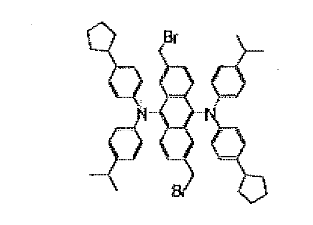 | 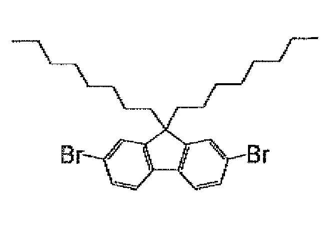 | 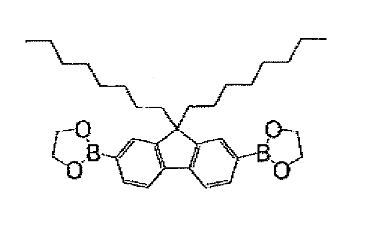 | None |

**Table 5**

| | Monomer 1 | Monomer 2 | Monomer 3 | Monomer 4 |
|---|---|---|---|---|
| Example 15 | 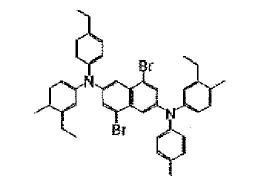 | 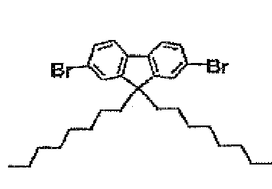 | 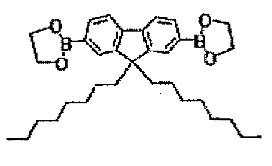 | None |
| Example 16 | 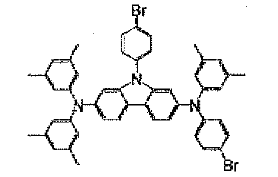 | 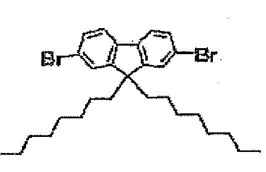 | 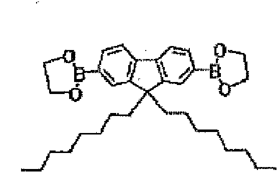 | 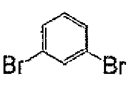 |
| Example 17 | 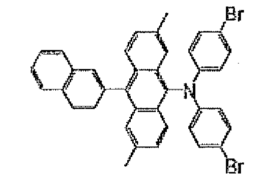 | 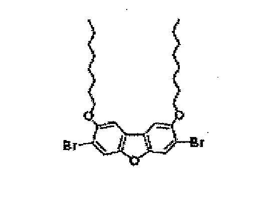 | 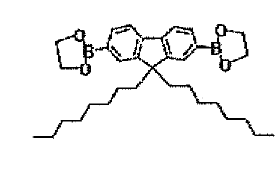 | None |
| Example 18 | 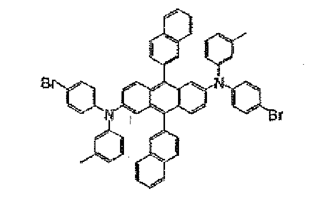 | 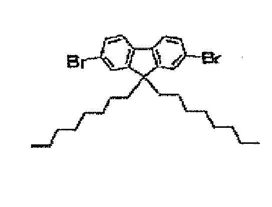 | 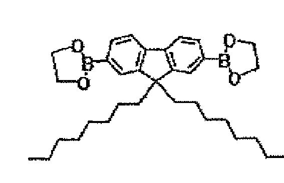 | None |

**Table 6**

| | Monomer 1 | Monomer 2 | Monomer 3 | Monomer 4 |
|---|---|---|---|---|
| Example 19 | 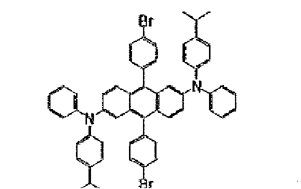 | 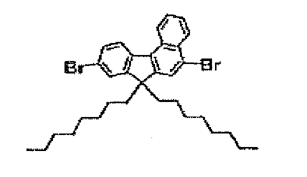 | 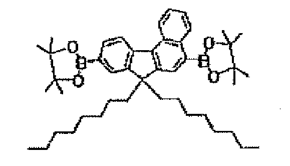 | None |
| Example 20 | 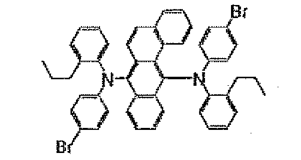 | 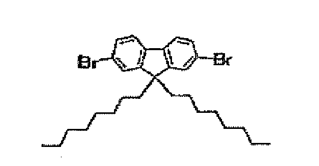 | 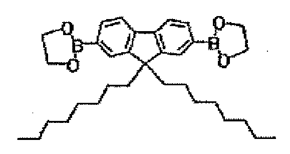 | None |
| Comparative Example 1 | 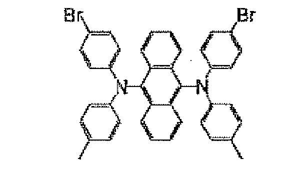 | 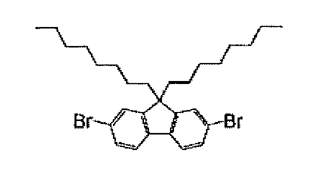 | 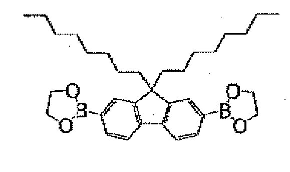 | None |
| Comparative Example 2 | 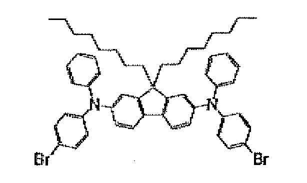 | 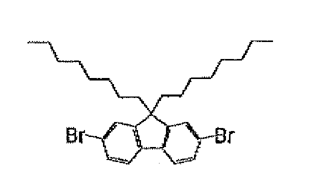 | 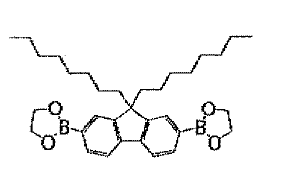 | None |

**Table 7**

| | Mn | Mw | Luminescent color | Peak wavelength (nm) | Maximum efficiency (cd/A) | Half life (@1000 nit) |
|---|---|---|---|---|---|---|
| Example 1 | 28,000 | 52,000 | Blue | 453 | 4.2 | 145 |
| Example 2 | 45,000 | 103,500 | Blue | 448 | 3.9 | 115 |
| Example 3 | 35,000 | 105,000 | Blue | 447 | 3.5 | 100 |
| Example 4 | 60,000 | 144,000 | Blue | 450 | 4 | 130 |
| Example 5 | 48,000 | 110,000 | Blue | 445 | 3.6 | 105 |
| Example 6 | 39,000 | 99,000 | Blue | 450 | 3.4 | 110 |
| Example 7 | 43,000 | 104,000 | Blue | 450 | 3.8 | 105 |
| Example 8 | 61,000 | 140,300 | Blue | 445 | 3.1 | 95 |
| Example 9 | 49,000 | 115,000 | Green | 535 | 13.5 | 425 |
| Example 10 | 55,000 | 136,000 | Green | 532 | 12.9 | 390 |
| Example 11 | 54,000 | 132,000 | Green | 536 | 11.5 | 270 |
| Example 12 | 59,000 | 140,000 | Green | 534 | 12 | 295 |

**Table 8**

| | Mn | Mw | Luminescent color | Peak Wavelength (nm) | Maximum efficiency (cd/A) | Half life (@1000 nit) |
|---|---|---|---|---|---|---|
| Example 13 | 57,000 | 146,000 | Blue | 451 | 4.1 | 140 |
| Example 14 | 60,000 | 15,000 | Green | 535 | 10.1 | 400 |
| Example 15 | 40,000 | 108,000 | Blue | 443 | 3.4 | 100 |
| Example 16 | 38,000 | 104,400 | Blue | 444 | 3.3 | 105 |
| Example 17 | 45,000 | 177,000 | Blue | 443 | 3.5 | 110 |
| Example 18 | 61,000 | 160,000 | Green | 536 | 10 | 410 |
| Example 19 | 39,000 | 155,000 | Green | 535 | 9.9 | 390 |
| Example 20 | 38,000 | 97,000 | Blue | 463 | 3.5 | 160 |
| Comparative Example 1 | 110,000 | 330,000 | Green | 530 | 9.7 | 180 |
| Comparative Example 1 | 28,000 | 52,000 | Blue | 460 | 3 | 5 |

### INDUSTRIAL APPLICABILITY

As explained above in detail, the high polymer compound of the present invention comprises a repeating unit having a function of a dopant and a repeating unit having a function of a host, and in particular, it is useful as a light emitting material and can provide an organic EL device which is excellent in performances such as a lifetime, a luminous efficiency and the like.

## Claims

1. A high polymer compound comprising a repeating unit A selected from divalent groups derived from compounds represented by the following Formulas (1) to (4) and a repeating unit B selected from the following Formulas (5) and (6): 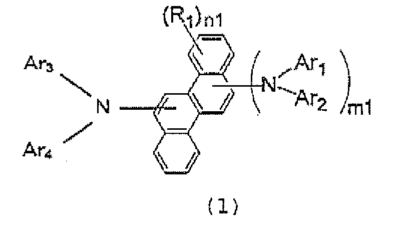 (wherein Ar₁ to Ar₄ each represent independently a substituted or non-substituted aryl group having 6 to 60 ring-forming carbon atoms or a substituted or non-substituted aromatic heterocyclic group having 3 to 40 ring-forming atoms, and Ar₁ to Ar₄ may be the same as or different from each other; R₁ represents a substituted or non-substituted alkyl group having 1 to 50 ring-forming carbon atoms, a substituted or non-substituted aryl group having 6 to 60 ring-forming carbon atoms, a substituted or non-substituted amino group, a substituted or non-substituted silyl group, a substituted or non-substituted alkoxy group having 1 to 50 ring-forming carbon atoms, a substituted or non-substituted aryloxy group having 6 to 50 ring-forming carbon atoms, a substituted or non-substituted arylthio group having 6 to 50 ring-forming carbon atoms, a substituted or non-substituted alkoxycarbonyl group having 1 to 50 ring-forming carbon atoms, a substituted or non-substituted aralkyl group having 7 to 31 carbon atoms, a halogen atom, a cyano group, a nitro group, a hydroxyl group or a carboxyl group, and the above respective groups may be combined with each other to form rings; m1 is an integer of 1 to 11, and n1 is an integer of 0 to 10); 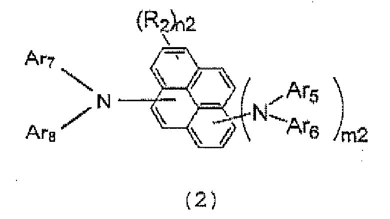 (wherein Ar₅ to Ar₈ each represent independently a substituted or non-substituted aryl group having 6 to 60 ring-forming carbon atoms or a substituted or non-substituted aromatic heterocyclic group having 3 to 40 ring-forming atoms, and Ar₅ to Ar₈ may be the same as or different from each other; R₂ represents a substituted or non-substituted alkyl group having 1 to 50 ring-forming carbon atoms, a substituted or non-substituted aryl group having 6 to 60 ring-forming carbon atoms, a substituted or non-substituted amino group, a substituted or non-substituted silyl group, a substituted or non-substituted alkoxy group having 1 to 50 ring-forming carbon atoms, a substituted or non-substituted aryloxy group having 1 to 50 ring-forming carbon atoms, a substituted or non-substituted arylthio group having 5 to 50 ring-forming atoms, a substituted or non-substituted alkoxycarbonyl group having 1 to 50 ring-forming carbon atoms, a substituted or non-substituted aralkyl group having 7 to 31 carbon atoms, a halogen atom, a cyano group, a nitro group, a hydroxyl group or a carboxyl group, and the above respective groups may be combined with each other to form rings; m2 is an integer of 1 to 9, and n2 is an integer of 0 to 8;
provided that excluded are a case where m2 is 1, where -NAr₇Ar₈ is bonded to a 2-position (or a 7-position) of the pyrene ring and where -NAr₅Ar₆ is bonded to a 7-position (or a 2-position) of the pyrene ring and a case where m2 is 1, where -NAr₇Ar₈ is bonded to a 4-position (or a 10-position) of the pyrene ring and where -NAr₅Ar₆ is bonded to a 10-position (or a 4-position) of the pyrene ring); 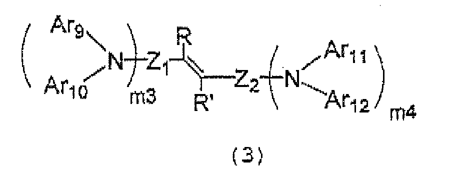 (wherein Ar₉ to Ar₁₂ each represent independently a substituted or non-substituted aryl group having 6 to 60 ring-forming carbon atoms or a substituted or non-substituted aromatic heterocyclic group having 3 to 40 ring-forming atoms, and Ar₉ to Ar₁₂ may be the same as or different from each other; Z₁ and Z₂ each represent independently a substituted or non-substituted aromatic hydrocarbon group having 6 to 60 ring-forming carbon atoms or a substituted or non-substituted aromatic heterocyclic group having 5 to 60 ring-forming atoms; R and R' each represent independently a hydrogen atom, a substituted or non-substituted alkyl group having 1 to 50 ring-forming carbon atoms or a substituted or non-substituted aryl group having 6 to 60 ring-forming carbon atoms; m3 and m4 each are an integer of 0 to 3;
R and R' or Z₁ and Z₂ may be bonded in either a cis position or a trans position based on the double bond in the center, and the compound represented by Formula (3) may be a mixture of a cis body and a trans body); 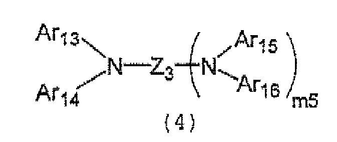 (wherein Ar₁₃ to Ar₁₆ each represent independently a substituted or non-substituted aryl group having 6 to 60 ring-forming carbon atoms or a substituted or non-substituted aromatic heterocyclic group having 3 to 40 ring-forming atoms, and Ar₁₃ to Ar₁₆ may be the same as or different from each other; Z₃ is a substituted or non-substituted aromatic hydrocarbon group having 6 to 60 ring-forming carbon atoms or a substituted or non-substituted aromatic heterocyclic group having 5 to 60 ring-forming atoms; m5 is an integer of 0 to 3; provided that when m5 is 1, excluded is a case where Z₃ is a non-substituted arylene group having 6 to 60 ring-forming carbon atoms and where all of Ar₁₃ to Ar₁₆ are a non-substituted aryl group having 6 to 60 ring-forming carbon atoms); 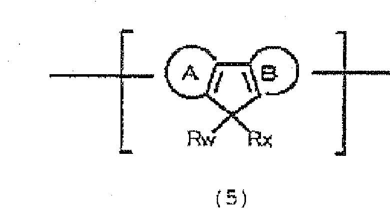 (wherein an A ring and a B ring each represent independently a substituted or non-substituted aryl group having 6 to 60 ring-forming carbon atoms or a substituted or non-substituted aromatic heterocyclic group having 3 to 40 ring-forming atoms; Rw and Rx each represent independently a hydrogen atom, a substituted or non-substituted alkyl group having 1 to 50 ring-forming carbon atoms, a substituted or non-substituted aryl group having 6 to 60 ring-forming carbon atoms, a substituted or non-substituted amino group, a substituted or non-substituted silyl group, a substituted or non-substituted alkoxy group having 1 to 50 ring-forming carbon atoms, a substituted or non-substituted aryloxy group having 6 to 50 ring-forming carbon atoms, a substituted or non-substituted arylthio group having 6 to 50 ring-forming carbon atoms, a substituted or non-substituted alkoxycarbonyl group having 1 to 50 ring-forming carbon atoms, a halogen atom, a cyano group, a nitro group, a hydroxyl group or a carboxyl group, and the above respective groups may be combined with each other to form rings); 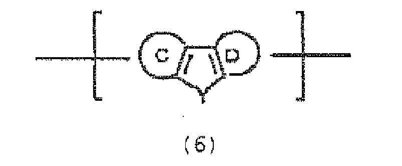 (wherein a C ring and a D ring each represent independently a substituted or non-substituted aromatic hydrocarbon ring having 6 to 60 ring-forming carbon atoms or a substituted or non-substituted aromatic heterocyclic ring having 3 to 40 ring-forming atoms; Y represents an oxygen atom, a substituted or non-substituted nitrogen atom, a substituted or non-substituted silicon atom, a substituted or non-substituted phosphorus atom, a sulfur atom, -O-C(Rk)₂- and -N(R1)-C(Rm)₂-; Rk and Rm represent a hydrogen atom, a substituted or non-substituted alkyl group having 1 to 50 ring-forming carbon atoms, a substituted or non-substituted aryl group having 6 to 60 ring-forming carbon atoms, a substituted or non-substituted amino group, a substituted or non-substituted silyl group, a substituted or non-substituted alkoxy group having 1 to 50 ring-forming carbon atoms, a substituted or noun-substituted aryloxy group having 6 to 50 ring-forming carbon atoms, a substituted or non-substituted arylthio group having 6 to 50 ring-forming carbon atoms, a substituted or non-substitutad alkoxycarbonyl group having 1 to 50 ring-forming carbon atoms, a halogen atom, a cyano group, a nitro group, a hydroxyl group or a carboxyl group, and the above respective groups may be combined with each other to form rings; each two groups of Rk and Rm may be the same as or different from each other; and Rl represents a hydrogen atom, a substituted or non-substituted alkyl group having 1 to 50 ring-forming carbon atoms or a substituted or non-substituted aryl group having 6 to 60 ring-forming carbon atoms).

2. The high polymer compound according to claim 1, wherein the repeating unit A is selected from the divalent groups derived from the compound represented by Formula (1).

3. The high polymer compound according to claim 1, wherein the repeating unit A is selected from the divalent groups derived from the compound represented by Formula (2).

4. The high polymer compound according to claim 1, wherein the repeating unit A is selected from the divalent groups derived from the compound represented by Formula (3).

5. The high polymer compound according to claim 1, wherein the repeating unit A is selected from the divalent groups derived from the compound represented by Formula (4).

6. The high polymer compound according to claim 1, wherein the compound represented by Formula (1) is a compound represented by the following Formula (1-a): 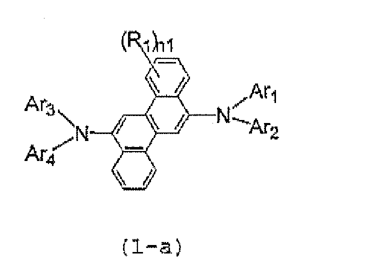 (in Formula (1-a), Ar₁ to Ar₄, R₁ and n1 each are the same as described above).

7. The high polymer compound according to claim 1, wherein the compound represented by Formula (2) is a compound represented by the following Formula (2-a) or (2-b): 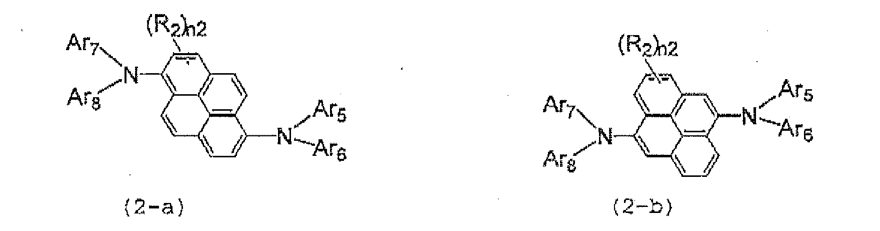 (in Formulas (2-a) and (2-b), Ar₅ to Ar₈, R₂ and n2 each are the same as described above).

8. The high polymer compound according to claim 1, wherein the compound represented by Formula (3) is a compound represented by the following Formula (3-a): 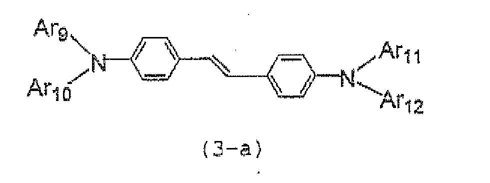 (wherein Ar₉ to Ar₁₂ each are independently the same as described above; provided that all of Ar₉ to Ar₁₂ show the same group).

9. The high polymer compound according to claim 1, wherein the compound represented by Formula (4) is a compound represented by the following Formula (4-a): 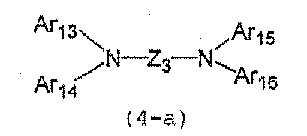 (wherein Ar₁₃ to Ar₁₆ and Z₃ each are independently the same as described above; provided that a valency of at least 1 is present in Z₃ in the center).

10. The high polymer compound according to any of claims 1 to 9, further comprising a repeating unit C selected from the following Formulas (7), (8), (9) and (10):
-Ar₁₇- (7) 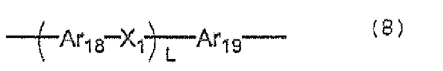
-Ar₂₀-X₂- (9)
-X₃- (10)
(wherein Ar₁₇, Ar₁₈, Ar₁₉ and Ar₂₀ each represent independently a substituted or non-substituted arylene group having 6 to 60 ring-forming carbon atoms, a substituted or non-substituted divalent aromatic heterocyclic group having 3 to 40 ring-forming atoms or a divalent group having a metal complex; X₁, X₂ and X₃ each represent independently -CR₃=CR₄-, -C≡C- or N(R₅)-; R₃ and R₄ each represent independently a hydrogen atom, an alkyl group, a substituted or non-substituted aryl group having 6 to 60 ring-forming carbon atoms, a substituted or non-substituted aromatic heterocyclic group having 3 to 40 ring-forming atoms, a substituted or non-substituted carboxyl group or a cyano group; R₅ represents a hydrogen atom, an alkyl group, a substituted or non-substituted aryl group having 6 to 60 ring-forming carbon atoms, a substituted or non-substituted aromatic heterocyclic group having 3 to 40 ring-forming atoms, a substituted or non-substituted aralkyl group having 7 to 60 ring-forming carbon atoms or a group containing a substituted amino group; L represents 1 or 2; when R₃, R₄ and R₅ each are plurally present, they may the same or different).

11. The high polymer compound according to claim 1 or 7, wherein in Formulas (2), (2-a) and (2-b), R₂ is bonded to the 3-position and the 8-position.

12. The high polymer compound according to claim 1 or 7, wherein in Formulas (2), (2-a) and (2-b), R₂ is an alkyl group or a substituted or non-substituted aryl group having 6 to 60 ring-forming carbon atoms.

13. The high polymer compound according to claim 1, wherein in Formulas (1), (2), (3) and (4), Ar₁ to Ar₁₆ are a substituted or non-substituted phenyl group.

14. The high polymer compound according to claim 1, wherein a repeating unit A selected from the divalent groups derived from the compounds represented by Formulas (1) to (4) described above is contained in a proportion of 0.1 or more and 99.9 mole % or less in a molecule.

15. A material for organic electroluminescence containing the high polymer compound according to claim 1.

16. The material for organic electroluminescence according to claim 15, further containing, in addition to the high polymer compound according to claim 1, at least one compound selected from the group consisting of a homopolymer comprising at least one repeating unit A selected from the divalent groups derived from the compounds represented by Formulas (1) to (4) according to claim 1 or a copolymer containing the above repeating unit A, a homopolymer comprising a repeating unit B selected from Formulas (5) and (6) according to claim 1 and a copolymer containing the above repeating unit B.

17. An organic electroluminescence device comprising an anode, a cathode and an organic compound layer comprising a layer interposed between the anode and the cathode, wherein a layer of the above organic compound layers is a light emitting layer, and the organic compound layer contains the material for organic electroluminescence according to claim 15.

18. The organic electroluminescence device according to claim 17, wherein the light emitting layer contains the high polymer compound according to claim 1 as a light emitting material.

19. The organic electroluminescence device according to claim 17, wherein the light emitting layer further contains a phosphorescent dopant and/or a fluorescent dopant.

20. The organic electroluminescence device according to claim 17, wherein the light emitting layer further contains an arylamine compound and/or a styrylamine compound.

21. The organic electroluminescence device according to claim 17, wherein the light emitting layer further contains a metal complex compound.

22. A solution containing the high polymer compound according to claim 1.

23. The solution according to claim 22 containing two or more kinds of organic solvents.

24. The solution according to claim 22 having a viscosity of 1 to 20 mPa·s at 25°C.

25. A method for forming a thin film in which a film is formed from the solution according to claim 22 by an ink jet method.
